# EUROPEAN PATENT APPLICATION

(11) **EP 4 779 432 A1**
(43) Date of publication of application: **22.07.2026**
(21) Application number: 25750534.7
(22) Date of filing: 12.08.2025
(51) Int. Cl.: G06F 1/16, H04M 1/02, H05K 5/02, F16C 11/04

(54) **FOLDABLE ELECTRONIC DEVICE COMPRISING HINGE ASSEMBLY**

(30) Priority: 27.11.2024 KR 20240172898 U; 30.12.2024 KR 20240200977
(71) Applicant: Samsung Electronics Co., Ltd, Suwon-si, Gyeonggi-do 16677 (KR)
(72) Inventor: KIM, Jongkeun, Suwon-si, Gyeonggi-do 16677 (KR); LEE, Jinju, Suwon-si, Gyeonggi-do 16677 (KR); SEO, Wonyoung, Suwon-si, Gyeonggi-do 16677 (KR)
(74) Representative: HGF
(86) International application number: PCT/KR2025/012209
(87) International publication number: WO 2026/116678

(57) **Abstract**

A foldable electronic device includes a foldable housing including a first housing part and a second housing part and a hinge assembly rotatably connecting the first housing part and the second housing part. The hinge assembly includes a first bracket, rotators rotatably coupled to the first bracket, arms configured to synchronize the rotation of the first housing part with the rotation of the second housing part, shafts, a second bracket including a first portion fastening the shafts and a second portion protruding from the first portion of the second bracket, and an elastic member pressing the second bracket. The second bracket, pressed by the elastic member, is secured to the first bracket via the second portion of the second bracket inserted into a groove of the first bracket.

## Description

### [Technical Field]

The present disclosure relates to a foldable electronic device including a hinge assembly.

### [Background Art]

An electronic device may include a foldable housing having a foldable structure to provide an improved user experience. For example, the electronic device may include one or more hinge assemblies rotatably connecting housing parts to each other. The one or more hinge assemblies may include components for rotatably connecting the housing parts. For example, the hinge assembly may include the components such as rotators, arms, gears, and shafts. The hinge assembly may include brackets for fastening the components.

The above-described information may be provided as a related art for a purpose of helping understanding of the present disclosure. No claim or determination is raised as to whether any of the above-described descriptions may be applied as a prior art related to the present disclosure.

### [Disclosure]

### [Technical Solution]

A foldable electronic device is disclosed. The foldable electronic device may comprise a foldable housing including a first housing part and a second housing part. The foldable electronic device may comprise a hinge assembly rotatably connecting the first housing part and the second housing part. The hinge assembly may include a first bracket. The hinge assembly may include rotators, rotatably coupled to the first bracket, configured to guide a rotation of the first housing part and a rotation of the second housing part. The hinge assembly may include arms configured to synchronize the rotation of the first housing part with the rotation of the second housing part. The hinge assembly may include a set of gears including driving gears configured to rotate in conjunction with a rotation of the arms, and one or more idle gears engaged with the driving gears. The hinge assembly may include shafts respectively coupled to the driving gears included in the set of gears. The hinge assembly may include a second bracket including a first portion fastening the shafts and a second portion protruding from the first portion of the second bracket. The hinge assembly may include an elastic member pressing the second bracket. The second bracket, pressed by the elastic member, may be secured to the first bracket via the second portion of the second bracket inserted into a groove of the first bracket.

A foldable electronic device is disclosed. The foldable electronic device may comprise a foldable housing including a first housing part and a second housing part. The foldable electronic device may comprise a hinge assembly rotatably connecting the first housing part and the second housing part. The foldable electronic device may comprise a hinge cover, at least partially covering the hinge assembly. The hinge assembly may include a first bracket. The hinge assembly may include rotators, rotatably coupled to the first bracket, configured to guide a rotation of the first housing part and a rotation of the second housing part. The hinge assembly may include arms configured to synchronize the rotation of the first housing part with the rotation of the second housing part. The hinge assembly may include a set of gears including driving gears configured to rotate in conjunction with a rotation of the arms, and one or more idle gears engaged with the driving gears. The hinge assembly may include shafts respectively coupled to the driving gears included in the set of gears. The hinge assembly may include a second bracket including a first portion fastening the shafts and a second portion protruding from the first portion of the second bracket. The hinge assembly may include an elastic member pressing the second bracket. The second bracket, pressed by the elastic member, may be secured to the hinge cover via the second portion of the second bracket inserted into a groove of the hinge cover.

A foldable electronic device is disclosed. The foldable electronic device may comprise a foldable housing including a first housing part, a second housing part, and a hinge cover disposed between the first housing part and the second housing part. The foldable electronic device may comprise a hinge assembly rotatably connecting the first housing part and the second housing part. The hinge assembly may include a first bracket, driving gears configured to rotate in conjunction with the rotation of the first housing part and the second housing part, shafts respectively coupled to the driving gears, a second bracket including a first portion contacted with the shafts and a second portion protruding from the first portion of the second bracket, and an elastic member pressing the second bracket. The second bracket, pressed by the elastic member, may be secured to the first bracket via the second portion of the second bracket inserted into a groove of the first bracket.

### [Description of the Drawings]

FIG. 1 is a block diagram of an electronic device in a network environment according to various embodiments.
FIG. 2A illustrates an example of an unfolded state of an electronic device according to an embodiment.
FIG. 2B illustrates an example of a folded state of an electronic device according to an embodiment.
FIG. 2C is an exploded view of an electronic device according to an embodiment.
FIG. 3 is an exploded perspective view of a hinge assembly of a foldable electronic device according to an embodiment.
FIG. 4 is an assembly diagram of the hinge assembly of FIG. 3.
FIGS. 5 and 6 are exploded views of an arm module and a first bracket of a hinge assembly according to an embodiment.
FIG. 7 is a perspective view of a second bracket.
FIG. 8 is a cross-sectional view in which the hinge assembly of FIG. 4 is cut along line A-A'.
FIG. 9 illustrates an arm module in a state before assembling a cam, an elastic member, and a second bracket.
FIG. 10 illustrates an arm module in a state in which a cam, an elastic member, and a second bracket are assembled to the arm module of FIG. 9.
FIG. 11 illustrates a process of seating an arm module on a first bracket.
FIGS. 12 and 13 illustrate processes in which a second bracket is secured to a first bracket.
FIGS. 14 and 15 illustrate processes in which an arm module is separated from a first bracket.
FIG. 16 illustrates a hinge assembly according to an embodiment.
FIG. 17 is a cross-sectional view in which the hinge assembly of FIG. 16 is cut along line B-B'.
FIG. 18 illustrates a foldable electronic device according to an embodiment.
FIG. 19 illustrates the second hinge assembly of FIG. 18.
FIG. 20 illustrates a hinge assembly including a first bracket including a lower bridge.
FIG. 21 illustrates a first bracket including a lower bridge.
FIG. 22 is a cross-sectional view in which the hinge assembly of FIG. 21 is cut along line C-C'.
FIG. 23 illustrates a hinge assembly including a first bracket including base portions.
FIG. 24 illustrates a first bracket including base portions.
FIG. 25 is a perspective view of a hinge assembly and a hinge cover.
FIG. 26 is a cross-sectional view in which the hinge assembly and the hinge cover of FIG. 25 are cut along line D-D'.

### [Mode for Invention]

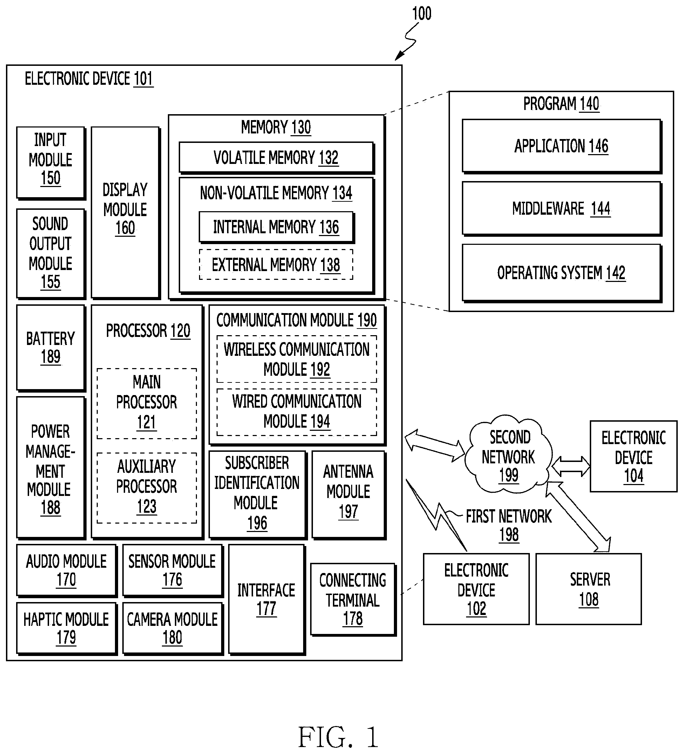

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

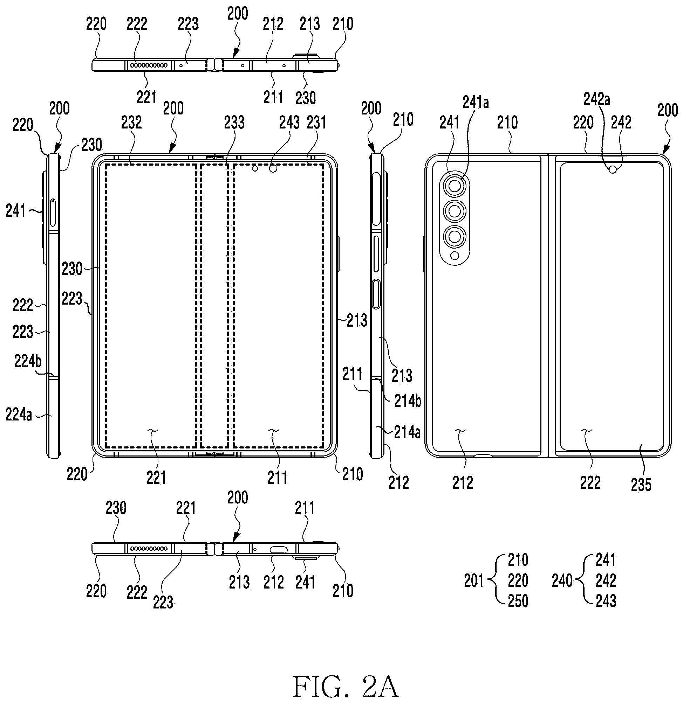

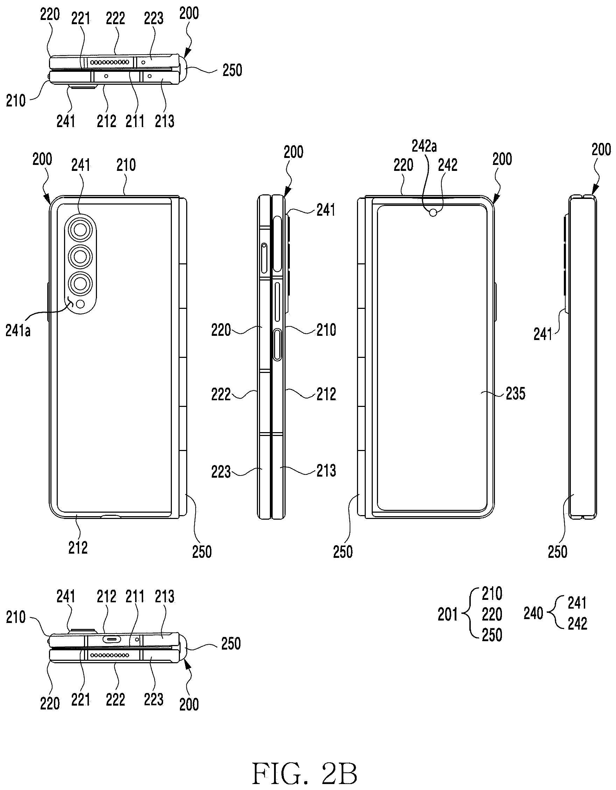

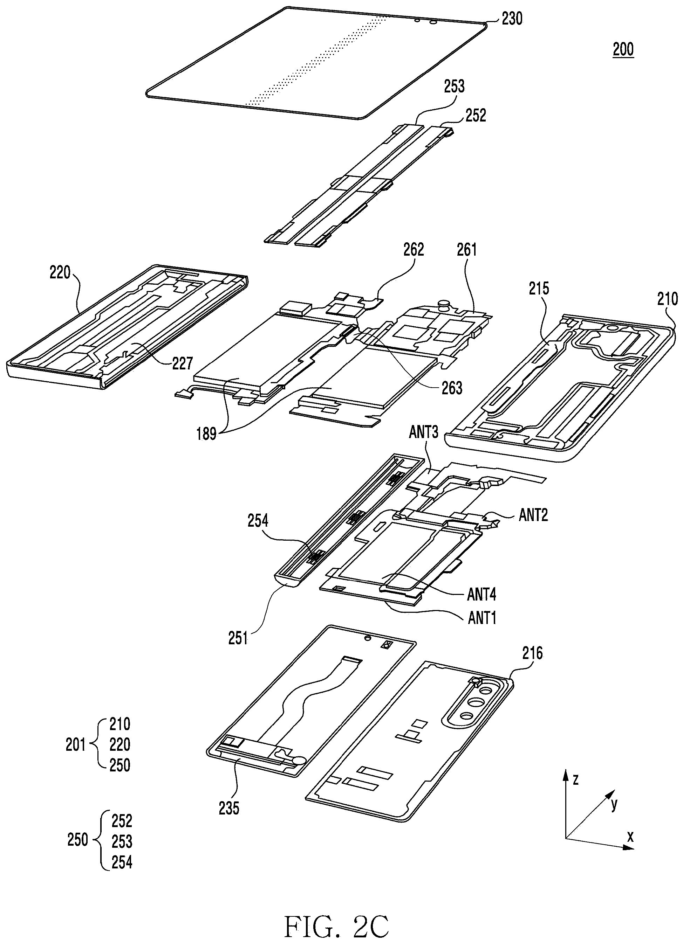

FIG. 2A illustrates an example of an unfolded state of an electronic device according to an embodiment. FIG. 2B illustrates an example of a folded state of an electronic device according to an embodiment. FIG. 2C is an exploded view of an electronic device according to an embodiment.

The electronic device 101 of FIG. 1 may include a foldable electronic device 200 to be described later. Referring to FIGS. 2A, 2B, and 2C, the foldable electronic device 200 according to an embodiment may include a foldable housing 201, a flexible display 230, one or more cameras 240, and a hinge assembly 250.

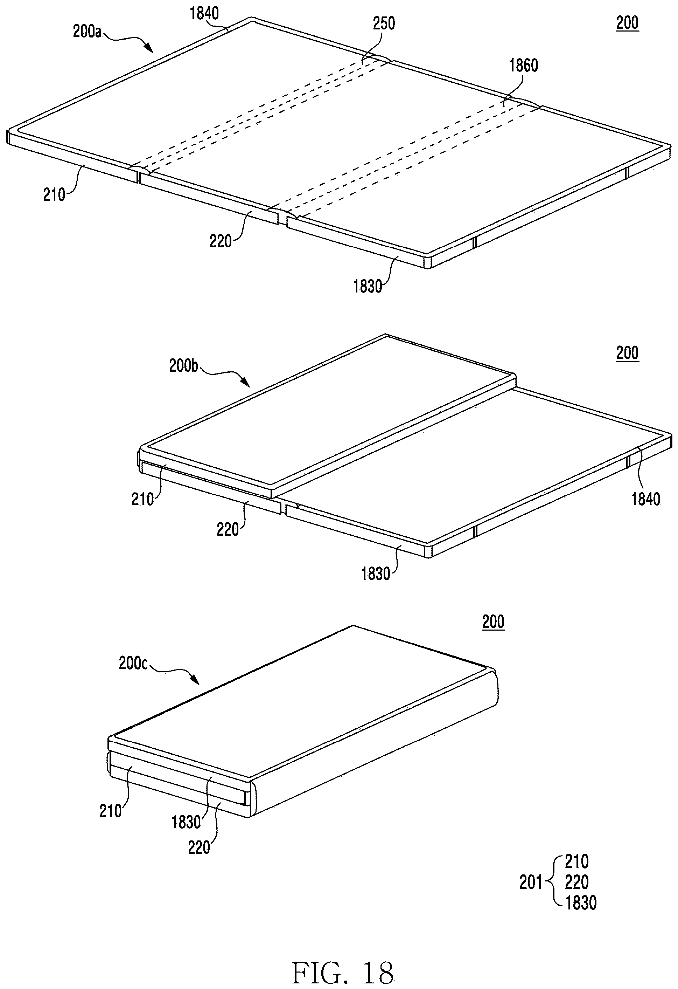

According to an embodiment, the foldable housing 201 may define an exterior of the foldable electronic device 200. For example, the foldable housing 201, which is a physical exterior of the foldable electronic device 200 exposed to an outside, may accommodate components disposed inside the foldable electronic device 200. At least some of the components for implementing a function of the foldable electronic device 200 may be disposed in the foldable housing 201. According to an embodiment, the foldable housing 201 may include a first housing part 210 and a second housing part 220. However, examples of the present disclosure are not limited thereto, and a foldable housing may also include three or more housing parts. An example of the foldable housing 201 including three housing parts will be described later with reference to FIG. 18.

According to an embodiment, the first housing part 210 may include a first surface 211, a second surface 212 opposite to the first surface 211, and a first lateral side 213 at least partially covering a periphery of the first surface 211 and a periphery of the second surface 212. For example, the first surface 211 may be referred to as a front side of the first housing part 210, and the second surface 212 may be referred to as a rear side of the first housing part 210. The first lateral side 213 may be connected with the periphery of the first surface 211 and the periphery of the second surface 212. The first surface 211, the second surface 212, and the first lateral side 213 may form an inner space of the first housing part 210. For example, at least one component may be disposed within a space covered by the first surface 211, the second surface 212, and the first lateral side 213.

According to an embodiment, the second housing part 220 may include a third surface 221, a fourth surface 222 opposite to the third surface 221, and a second lateral side 223 at least partially covering a periphery of the third surface 221 and a periphery of the fourth surface 222. For example, the third surface 221 may be referred to as a front side of the second housing part 220, and the fourth surface 222 may be referred to as a rear side of the second housing part 220. The second lateral side 223 may be connected with the periphery of the third surface 221 and the periphery of the fourth surface 222. The third surface 221, the fourth surface 222, and the second lateral side 223 may form an inner space of the second housing part 220. For example, at least one component may be disposed within a space covered by the third surface 221, the fourth surface 222, and the second lateral side 223.

According to an embodiment, the flexible display 230 may be configured to display visual information. For example, the flexible display 230 may include a display region including a plurality of sub-pixels. For example, an active region may be referred to as an active region displaying the visual information.

According to an embodiment, the flexible display 230 may include a first portion 231, a second portion 232, and a third portion 233 extending from the first portion 231 to the second portion 232. The foldable electronic device 200 may further include a cover display 235 distinguished from the flexible display 230. The cover display 235 may be referred to as a sub-display.

According to an embodiment, the first portion 231 of the flexible display 230 may be at least partially supported by the first housing part 210 by being disposed on the first housing part 210. The second portion 232 of the flexible display 230 may be at least partially supported by the second housing part 220 by being disposed on the second housing part 220. The first portion 231 of the flexible display 230 and the second portion 232 of the flexible display 230 may be substantially flat independently of a state (e.g., the unfolded state, an intermediate state, and the folded state) of the foldable electronic device 200. The intermediate state may be referred to as a partially folded state or a partially unfolded state.

According to an embodiment, the third portion 233 of the flexible display 230 may be configured to be at least partially bent based on a rotation of the first housing part 210 and/or a rotation of the second housing part 220. For example, the third portion 233 may be substantially flat in the unfolded state in which the first housing part 210 and the second housing part 220 are unfolded. The third portion 233 may be at least partially bent in the folded state or the intermediate state in which the first housing part 210 and the second housing part 220 are folded. The flexible display 230 may be a flexible display including a bendable third portion 233. The intermediate state may be referred to as a partially folded state of a partially unfolded state.

According to an embodiment, the one or more cameras 240 may be configured to obtain an image or a video based on receiving light from an external subject of the foldable electronic device 200. For example, the one or more cameras 240 may include first cameras 241, a second camera 242, and/or a third camera 243. For example, the first cameras 241 may be disposed in the first housing part 210. For example, the first housing part 210 may define (or form) at least one opening 241a overlapping the first cameras 241 when the foldable electronic device 200 is viewed from above. The first cameras 241 may obtain an image based on receiving the light from the outside of the foldable electronic device 200 via the at least one opening 241a. The first cameras 241 may face a rear side of the foldable electronic device 200.

According to an embodiment, the second camera 242 may be disposed in the second housing part 220. The second housing part 220 may define (or form) at least one opening 242a overlapping the second camera 242 when the foldable electronic device 200 is viewed from above. The second camera 242 may obtain an image based on receiving the light from the outside of the foldable electronic device 200 via the at least one opening 242a. The second camera 242 may face the rear side of the foldable electronic device 200. The first cameras 241 and the second camera 242 may be referred to as a rear camera in terms of facing the rear side of the foldable electronic device 200.

According to an embodiment, the third camera 243 may be disposed in the first housing part 210. For example, the first portion 231 of the flexible display 230 may define (or form) at least one opening overlapping the third camera 243 when the flexible display 230 is viewed from above. The third camera 243 may obtain an image based on receiving light from the outside of the flexible display 230 via the at least one opening. The third camera 243 may face a front side of the foldable electronic device 200. The third camera 243 may be referred to as a front camera in terms of facing the front side of the foldable electronic device.

According to an embodiment, the second camera 242 and the third camera 243 may be disposed below (e.g., in a -z direction) the flexible display 230 or the cover display 235. For example, the second camera 242 and/or the third camera 243 may include an under display camera (UDC) and/or a punch hole camera.

According to an embodiment, the first housing part 210 and the second housing part 220 may be rotatably coupled. For example, the second housing part 220 may be rotatably coupled to the first housing part 210 via the hinge assembly 250. The hinge assembly 250 may include components rotatably connecting the first housing part 210 and the second housing part 220.

According to an embodiment, the hinge assembly 250 may rotatably connect the first housing part 210 and the second housing part 220. The hinge assembly 250 may be disposed between the first housing part 210 and the second housing part 220 of the foldable electronic device 200 so that the foldable electronic device 200 may be folded. The hinge assembly 250 may enable the foldable electronic device 200 to change from the unfolded state to the folded state. The hinge assembly 250 may enable the foldable electronic device 200 to change from the folded state to the unfolded state. For example, the hinge assembly 250 may maintain the foldable electronic device 200 in a partially folded state (or a partially unfolded state) between the unfolded state and the folded state.

According to an embodiment, the unfolded state may be referred to as a state in which a first direction toward which the first portion 231 faces and a second direction toward which the second portion 232 faces are substantially the same. The folded state may be referred to as a state in which the first direction is substantially opposite to the second direction. When the foldable electronic device 200 is in the folded state, the first housing part 210 and the second housing part 220 may overlap each other.

According to an embodiment, when the foldable electronic device 200 is in the folded state and the intermediate state, the first direction and the second direction may be different from each other. For example, when the foldable electronic device 200 is in the folded state, the first direction and the second direction may be opposite to each other. For example, when the foldable electronic device 200 is in the intermediate state, the first direction may form an angle with respect to the second direction.

For example, the foldable electronic device 200 may include at least one conductive portions 214a and 224a and at least one non-conductive portions 214b and 224b included in the first lateral side 213 and/or the second lateral side 223. For example, the at least one conductive portions 214a and 224a may be separated from another conductive portion in the first lateral side 213 and/or the second lateral side 223 by contacting the at least one non-conductive portions 214b and 224b. In an embodiment, the at least one conductive portions 214a and 224a may operate as an antenna radiator to be used for a communication with an external electronic device.

Referring to FIG. 2C, the hinge assembly 250 may be at least partially covered by the hinge cover 251. The hinge assembly 250 may include a first hinge plate 252, a second hinge plate 253, and a plurality of hinge modules 254. The hinge cover 251 may at least partially cover components of the hinge assembly 250 and protect the components of the hinge assembly 250. When the foldable electronic device 200 is in the folded state, the hinge cover 251 may be at least partially exposed to the outside of the foldable electronic device 200 via a space between the first housing part 210 and the second housing part 220. When the foldable electronic device 200 is in the unfolded state, the hinge cover 251 may be blocked by the first housing part 210 and the second housing part 220. The hinge cover 251 may be referred to as a hinge housing.

According to an embodiment, the first hinge plate 252 and the second hinge plate 253 may be operatively coupled with the first housing part 210 and the second housing part 220, respectively, thereby rotatably connecting the first housing part 210 and the second housing part 220. For example, the first hinge plate 252 may be coupled with a first support portion 215 of the first housing part 210, and the second hinge plate 253 may be coupled with a second support portion 227 of the second housing part 220. As the first hinge plate 252 and the second hinge plate 253 are operatively coupled to the first support portion 215 and the second support portion 227, respectively, the first housing part 210 and the second housing part 220 may be rotatable according to a rotation of the first hinge plate 252 and the second hinge plate 253.

According to an embodiment, the plurality of hinge modules 254 may rotate the first hinge plate 252 and the second hinge plate 253. For example, the plurality of hinge modules 254 may include gears that are rotatable by engaging with each other. The first hinge plate 252 and the second hinge plate 253 may be rotated based on a rotation movement of the gears of the plurality of hinge modules 254.

According to an embodiment, the first housing part 210 may include the first support portion 215 and a rear cover 216. The first support portion 215 may be disposed inside the first housing part 210 and support at least one component disposed in the first housing part 210. The rear cover 216 may at least partially form the second surface 212 of the first housing part 210. For example, the second housing part 220 may include the second support portion 227. The second support portion 227 may be disposed inside the second housing part 220 and support at least one component disposed in the second housing part 220. For example, the cover display 235 may be disposed below (e.g., in the -z direction) the second support portion 227. According to an embodiment, a flexible display (e.g., the flexible display 230 of FIG. 2A) may define the front side of the foldable electronic device 200, and the rear cover 216 opposite to the flexible display may define the rear side of the foldable electronic device 200.

The foldable electronic device 200 according to an embodiment may include a plurality of electronic components for implementing various functions in addition to the one or more cameras 240 described above. For example, the foldable electronic device 200 may include a first printed circuit board 261, a second printed circuit board 262, a flexible printed circuit board 263, and/or a battery 189. The electronic components described above are exemplary only and are not limited thereto.

For example, the first printed circuit board 261 and the second printed circuit board 262 may each provide an electrical connection of the components in the foldable electronic device 200. For example, the first printed circuit board 261 may be disposed in the first housing part 210, and the second printed circuit board 262 may be disposed in the second housing part 220. The first printed circuit board 261 may provide an electrical connection between electronic components disposed in the first housing part 210. The second printed circuit board 262 may provide an electrical connection between electronic components disposed in the second housing part 220. The flexible printed circuit board 263 may electrically connect the first printed circuit board 261 and the second printed circuit board 262. For example, the flexible printed circuit board 263 may extend from the first printed circuit board 261 to the second printed circuit board 262 across the hinge assembly 250. For example, the flexible printed circuit board 263 may at least partially overlap the hinge assembly 250.

According to an embodiment, the battery 189, which is a device for supplying a power to at least one component of the foldable electronic device 200, may include, for example, a non-rechargeable primary battery and/or a rechargeable secondary battery.

According to an embodiment, the foldable electronic device 200 may include a plurality of antennas ANT1, ANT2, ANT3, or ANT4 to be used for the communication with the external electronic device. For example, the foldable electronic device 200 may include the main antenna ANT1, the sub-antenna ANT2, the ultra-wide band (UWB) antenna ANT3, and/or the antenna ANT4 for a short-range wireless communication. However, it is not limited thereto. For example, the main antenna ANT1 may include one or more conductive portions forming at least a portion of the first housing part 210 or the second housing part 220. For example, the main antenna ANT1 may include a plurality of conductive portions forming a periphery portion of the first housing part 210. For example, the main antenna ANT1 may further include conductive portions forming an upper periphery or a side periphery of the first housing part 210. The main antenna ANT1 may be configured to transmit and/or receive signals of various frequency bands via each of the plurality of conductive portions or a combination of the plurality of conductive portions.

According to an embodiment, the hinge assembly 250 may be configured to provide an unfolding movement and a folding movement of the foldable electronic device 200. In the present disclosure, the folding movement may be referred to as a movement of the foldable electronic device 200 for changing a state of the foldable electronic device 200 from the unfolded state (e.g., the state illustrated in FIG. 2A) to the folded state (e.g., the state illustrated in FIG. 2B). For example, the folding movement may be referred to as a movement in which the first housing part 210 rotates in a first rotation direction (e.g., counterclockwise) relative to the second housing part 220 and the second housing part 220 rotates in a second rotation direction (e.g., clockwise) opposite to the first rotation direction relative to the first housing part 210. In the present disclosure, the unfolding movement may be referred to as a movement of the foldable electronic device 200 that changes a state of the foldable electronic device 200 from the folded state to the unfolded state. For example, the unfolding movement may be referred to as a movement in which the first housing part 210 rotates in the second rotation direction relative to the second housing part 220 and the second housing part 220 rotates in the first rotation direction relative to the first housing part 210.

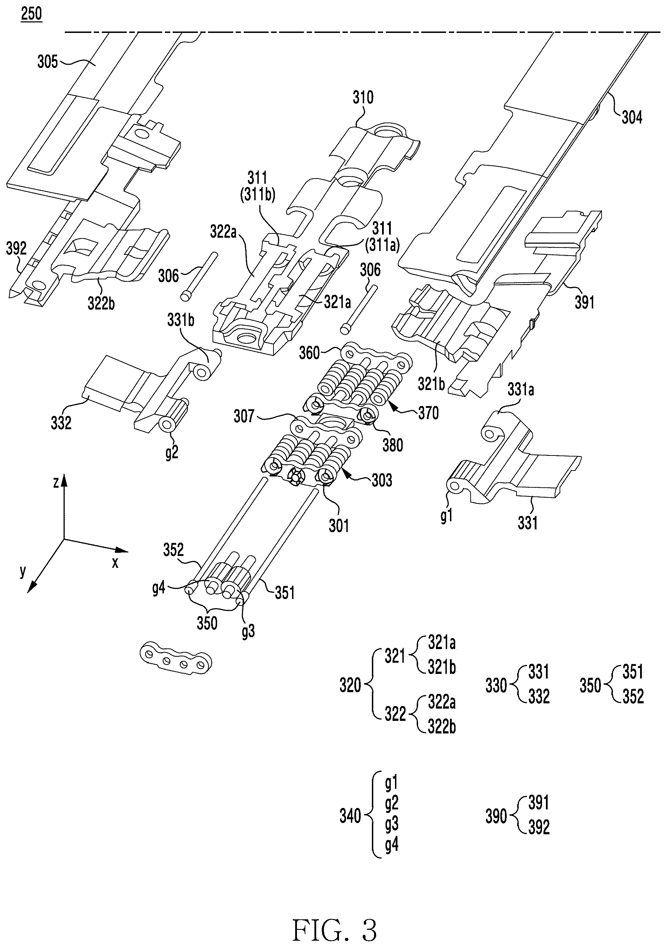

In a case that the hinge assembly 250 includes a separate structure (e.g., a ring structure) for fastening shafts (e.g., shafts 350 of FIG. 3), an increase in a thickness of the hinge assembly 250 is caused. To enable the structure to be secured to the shafts 350, at least one shaft of the shafts 350 includes a groove into which the structure may be inserted and fastened. In order to form the groove, a thickness of the shafts 350 having greater than or equal to a predetermined thickness is required.

The foldable electronic device 200 according to an embodiment may include a shaft bracket (e.g., a second shaft 352 of FIG. 3) that is directly secured to a rotator bracket (e.g., a first bracket 310 of FIG. 3) without including the separate structure for fastening the shafts 350. Hereinafter, a structure of the hinge assembly 250 will be described.

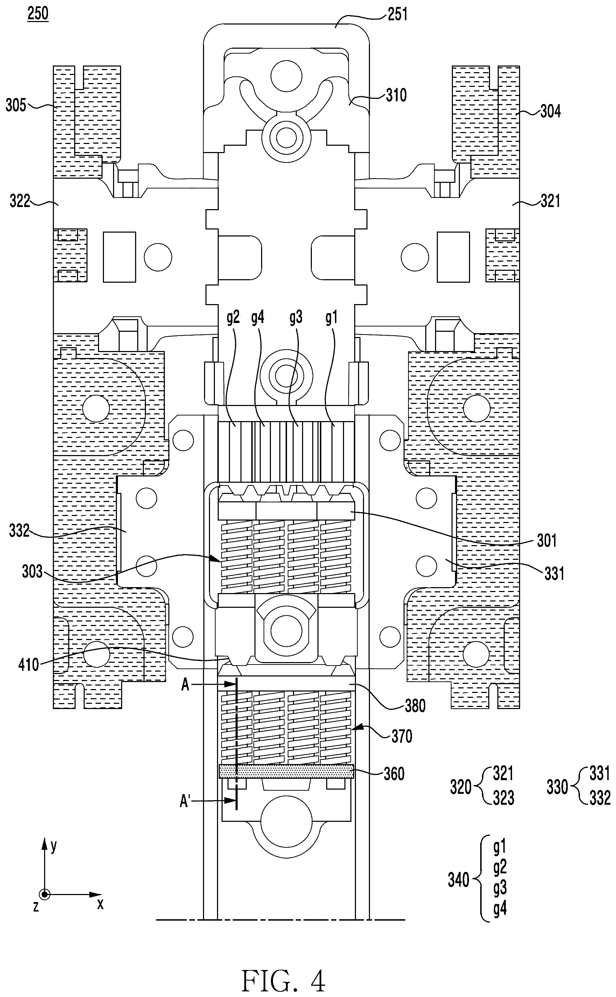

FIG. 3 is an exploded perspective view of a hinge assembly of a foldable electronic device according to an embodiment. FIG. 4 is an assembly diagram of the hinge assembly of FIG. 3.

According to an embodiment, a hinge assembly 250 may include components for rotatably connecting a first housing part (e.g., the first housing part 210 of FIG. 2A) and a second housing part (e.g., the second housing part 220 of FIG. 2A). The components of the hinge assembly 250 illustrated in FIG. 3 may be included in one of the hinge modules 254 of FIG. 2C. For example, a first housing part 210 and a second housing part 220 may be rotatably connected to each other via the hinge assembly 250. When an external force is applied to the first housing part 210 and/or the second housing part 220, the components of the hinge assembly 250 may operate in response to the external force. The external force may be referred to as torque provided from a user to the first housing part 210 and/or the second housing part 220, in order to change a state of the foldable electronic device (e.g., the foldable electronic device 200 of FIG. 2A).

Referring to FIGS. 3 and 4, the hinge assembly 250 may include a first bracket 310, rotators 320, arms 330, a set of gears 340, shafts 350 (e.g., a first shaft 351 and a second shaft 352), a second bracket 360, and/or an elastic member 370.

According to an embodiment, the rotators 320 may be configured to guide a rotation of the first housing part 210 and a rotation of the second housing part 220. For example, the rotators 320 may include a first rotator 321 configured to guide the rotation of the first housing part 210 and a second rotator 322 configured to guide the rotation of the second housing part 220.

According to an embodiment, the first bracket 310 may be configured to guide a rotation of the rotators 320. For example, the rotators 320 may be rotatably coupled to the first bracket 310. For example, the first bracket 310 may include a first rail portion 311a to which the first rotator 321 is rotatably coupled and a second rail portion 311b to which the second rotator 322 is rotatably coupled. The first rotator 321 may be inserted into the first rail portion 311a of the first bracket 310 and rotate along the first rail portion 311a. The second rotator 322 may be inserted into the second rail portion 311b of the first bracket 310 and rotate along the second rail portion 311b.

For example, the first bracket 310 may partially cover the hinge assembly 250 and may be secured to a hinge cover (e.g., a hinge cover 251 of FIG. 4) disposed between the first housing part 210 and the second housing part 220. For example, via a screw secured to the hinge cover 251 by penetrating the first bracket 310, the first bracket 310 may be secured to the hinge cover 251. The first bracket 310 may be referred to as a rotator bracket in terms of being rotatably coupled with the rotators 320.

According to an embodiment, each of the first rotator 321 and the second rotator 322 may include two or more sub-rotators. For example, the first rotator 321 may include a first sub-rotator 321a coupled to the first bracket 310 and a second sub-rotator 321b coupled to the first sub-rotator 321a. For example, the second rotator 322 may include a third sub-rotator 322a coupled to the second bracket 360 and a fourth sub-rotator 322b coupled to the third sub-rotator 322a. The second sub-rotator 321b and the fourth sub-rotator 322b may be configured to rotate in conjunction with the rotation of the first housing part 210 or the rotation of the second housing part 220 by being coupled to a coupling bracket to be described later. When the foldable electronic device 200 is in the folding movement or the unfolding movement, rotation angles of each of the two or more sub-rotators may be different. For example, when the foldable electronic device 200 is in the folding movement or the unfolding movement, a rotation angle of the first sub-rotator 321a and a rotation angle of the third sub-rotator 322a may be different from a rotation angle of the second sub-rotator 321b and a rotation angle of the fourth sub-rotator 322b. For example, during the folding movement or the unfolding movement, the rotation angle of the first sub-rotator 321a and the rotation angle of the third sub-rotator 322a may be smaller than the rotation angle of the second sub-rotator 321b and the rotation angle of the fourth sub-rotator 322b. As the rotators 320 include the two or more sub-rotators, a coupling area between the rotators 320 and the first bracket 310 may increase in a folded state of the foldable electronic device 200. For example, the coupling area may be referred to as an area of a portion where the rotators 320 and the first bracket 310 are in contact with each other. When the foldable electronic device 200 is changed from an unfolded state to the folded state, the rotators 320 may be rotated with respect to the first bracket 310. According to the rotation of the rotators 320, the contacted portion between the rotators 320 and the first bracket 310 may be decreased, so that the coupling area between the rotators 320 and the first bracket 310 may be decreased. In a case that the rotators 320 include the two or more sub-rotators, the first sub-rotator 321a and the third sub-rotator 322a directly coupled to the first bracket 310 may rotate at an angle smaller than the second sub-rotator 321b and the fourth sub-rotator 322b. Since the rotation angle of the first sub-rotator 321a and the rotation angle of the third sub-rotator 322a are smaller than the rotation angle of the second sub-rotator 321b and the rotation angle of the fourth sub-rotator 322b, the coupling area may be relatively increased in the folded state of the foldable electronic device 200. According to the increase of the coupling area, the rotators 320 may be stably coupled to the first bracket 310.

According to an embodiment, the hinge assembly 250 may further include a gear bracket 307. The gear bracket 307 may be configured to fasten a rotation shaft of each gear of the set of gears 340.

According to an embodiment, the arms 330 and the set of gears 340 may be configured to synchronize the rotation of the first housing part 210 with the rotation of the second housing part 220. For example, the arms 330 may include a first arm 331 configured to rotate in conjunction with the rotation of the first housing part 210 and a second arm 332 configured to rotate in conjunction with the rotation of the second housing part 220. The arms 330 may be respectively coupled to coupling brackets 390. For example, the first arm 331 may be coupled to a first coupling bracket 391, and the second arm 332 may be coupled to a second coupling bracket 392.

According to an embodiment, the set of gears 340 may be configured to synchronize with the rotation of the arms 330. For example, the set of gears 340 may include driving gears g1 and g2 configured to rotate in conjunction with the rotation of the arms 330 and one or more idle gears g3 and g4 engaged with the driving gears g1 and g2. For example, the set of gears 340 may include the first gear g1 and the second gear g2 corresponding to the driving gears g1 and g2, the third gear g3 and the fourth gear g4 corresponding to the one or more idle gears g3 and g4. The one or more idle gears may include a single gear, or the one or more idle gears may include two or more gears.

For example, the first gear g1 may be integrally formed with the first arm 331 by being connected to the first arm 331. For example, the second gear g2 may be integrally formed with the second arm 332 by being connected to the second arm 332. For example, the third gear g3 and the fourth gear g4 may be configured to transmit a power (e.g., torque) by being disposed between the first gear g1 and the second gear g2. The third gear g3 may be engaged with the first gear g1, and may be engaged with the fourth gear g4. The fourth gear g4 may be engaged with the second gear g2, and may be engaged with the third gear g3.

For example, when the first arm 331 rotates, the first gear g1 integrally formed with the first arm 331 may rotate. The rotation of the first gear g1 may cause a rotation of the third gear g3 engaged with the first gear g1. The rotation of the third gear g3 may cause a rotation of the fourth gear g4 engaged with the third gear g3. The rotation of the fourth gear g4 may cause a rotation of the second gear g2 engaged with the fourth gear g4. According to the rotation of the second gear g2, a rotation of the second arm 332 integrally formed with the second gear g2 may be caused.

According to an embodiment, the shafts 350 may be configured to provide a rotation shaft of the arms 330 and the driving gears g1 and g2. The shafts 350 may be coupled to each of the driving gears g1 and g2 included in the set of gears 340. For example, the shafts 350 may include the first shaft 351 coupled to the first gear g1 and the second shaft 352 coupled to the second gear g2. The first shaft 351 may be inserted into the first gear g1 integrally formed with the first arm 331. The first arm 331 may include a first support portion 331a into which a portion of the first shaft 351 passing through the first gear g1 is inserted. The second shaft 352 may be inserted into the second gear g2 integrally formed with the second arm 332. The second arm 332 may include a second support portion 332a into which a portion of the second shaft 352 passing through the second gear g2 is inserted.

According to an embodiment, the elastic member 370 together with a cam 380 may be configured to function as a detent providing an intermediate state of the foldable electronic device 200 between the folded state and the unfolded state. For example, a surface of the cam 380 may be in contact with the arms 330, and another surface of the cam 380 opposite to the surface may be in contact with the elastic member 370. However, it is not limited thereto. For example, the cam 380 may not directly contact with the elastic member 370, and a separate mechanism (e.g., a washer) may be disposed between the cam 380 and the elastic member 370. The mechanism may be interposed between the elastic member 370 and the cam 380. Each of the arms 330 contacted with the surface of the cam 380 may include a cam portion (e.g., a cam portion 410 of FIG. 4) engaged with the cam 380. As the arms 330 rotate, the cam portion 410 of the arms 330 contacted with the surface of the cam 380 may rotate. According to the rotation of the cam portion 410, as the cam portion 410 moves along a ridge of the cam 380, a contact position between the cam portion 410 and the cam 380 may be changed. According to the contact position between the cam portion 410 and the cam 380, a frictional force between the cam 380 and the cam portion 410 may increase at a position where a contact area between the cam portion 410 and the cam 380 increases. Due to the frictional force, the first housing part 210 and the second housing part 220 may maintain a state of being rotated by a predetermined angle. The state may be referred to as the intermediate state of the foldable electronic device 200. The intermediate state, which is a state between the folded state and the unfolded state, may be referred to as a pre-stop state or a flex mode. The frictional force may provide a tactile feedback to the user during the folding movement or the unfolding movement.

For example, according to the rotation of the cam portion 410, the cam portion 410 may press the cam 380. The cam 380 may be configured to compress the elastic member 370 based on the pressure from the cam portion 410 in accordance with the rotation of the arms 330. For example, the cam 380 (e.g., a first cam) pressed by the cam portion 410, may move to press the elastic member 370 (e.g., a first elastic member). By being pressed by the cam 380, the elastic member 370 may be compressed. In the intermediate state, as the arms 330 rotate, the contact position between the cam portion 410 and the cam 380 is changed, and the pressure from the cam portion 410 may be released. According to the release of the pressure, the elastic member 370 may be extended by a restoring force of the elastic member 370. According to the extension of the elastic member 370, the cam 380 may move to its original position. The hinge assembly 250 may further include another cam 301 (e.g., a second cam) and another elastic member 303 (e.g., a second elastic member) corresponding to the cam 380 and the elastic member 370 described above, respectively.

According to an embodiment, the elastic member 370 may be disposed in the hinge assembly 250 in a compressed state. The second bracket 360 may fasten the shafts 350 and the elastic member 370. The rotators 320, the arms 330, the shafts 350, and the elastic member 370 may be fastened to the first bracket 310 via the second bracket 360. For example, the shafts 350 and the elastic member 370 may be coupled to the second bracket 360, and the second bracket 360 may be secured to the first bracket 310 in a state of being coupled with the shafts 350 and the elastic member 370. As the second bracket 360 is secured to the first bracket 310, a position of the rotators 320, the arms 330, the shafts 350, and the elastic member 370 may be fastened. The second bracket 360 may be referred to as a shaft bracket in terms of fastening the shafts 350. The second bracket 360 may be separated from the hinge cover 251 without being directly secured to the hinge cover 251. The structure in which the second bracket 360 is separated from the hinge cover 251 may be referred to as a structure in which the second bracket 360 and the hinge cover 251 are not directly secured. The first bracket 310 may fasten the second bracket 360 by being secured to the hinge cover 251 in a state of being secured with the second bracket 360.

According to an embodiment, the hinge assembly 250 may include the coupling brackets 390. The rotators 320 and the arms 330 may be coupled to the coupling brackets 390, respectively. For example, the first rotator 321 and the first arm 331 may be coupled to the first coupling bracket 391, and the second rotator 322 and the second arm 332 may be coupled to the second coupling bracket 392. The coupling brackets 390 may be coupled to a foldable housing 201. For example, the first coupling bracket 391 may be coupled to the first housing part 210, and the second coupling bracket 392 may be coupled to the second housing part 220.

According to an embodiment, the hinge assembly 250 may include support plates 304 and 305. The support plates 304 and 305 may be configured to support a third portion (e.g., the third portion 233 of FIG. 2A) of a flexible display (e.g., the flexible display 230 of FIG. 2A). The support plates 304 and 305 may be respectively coupled to the rotators 320 and the coupling brackets 390. For example, the support plates 304 and 305 may include the first support plate 304 respectively coupled to the first rotator 321 and the first coupling bracket 391, and the second support plate 305 respectively coupled to the second rotator 322 and the second coupling bracket 392. The hinge assembly 250 may include pins 306 for coupling each of the rotators 320 to each of the support plates 304 and 305.

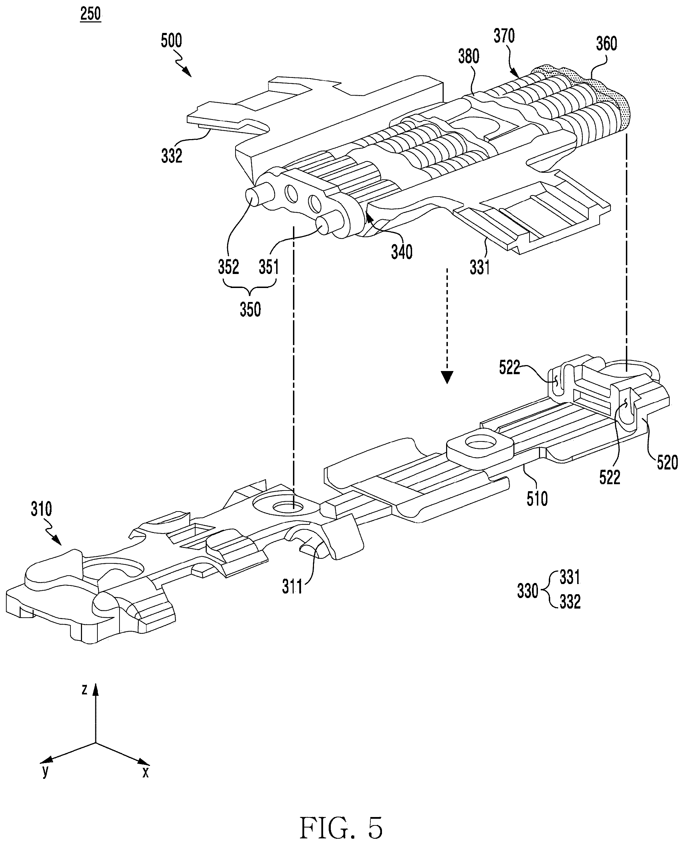

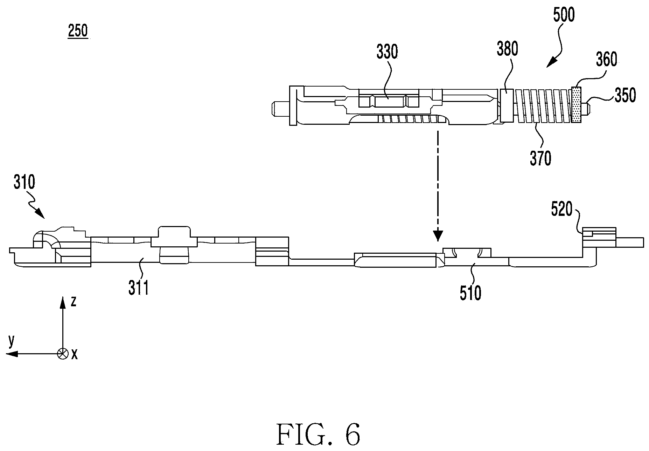

FIGS. 5 and 6 are exploded views of an arm module and a first bracket of a hinge assembly according to an embodiment.

In a description to be described later, an arm module 500 may be referred to as a component of a hinge assembly 250 including arms 330 (e.g., a first arm 331 and a second arm 332), a set of gears 340, shafts 350 (e.g., a first shaft 351 and a second shaft 352), a cam 380, an elastic member 370, and a second bracket 360.

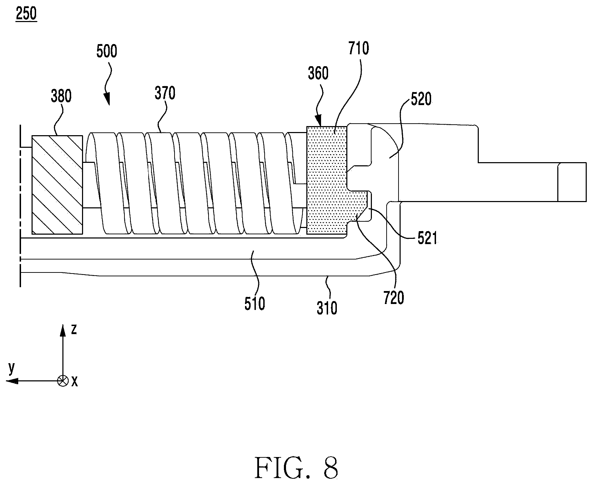

Referring to FIGS. 5 and 6, the arm module 500 may be seated on a first bracket 310. For example, the arm module 500 may be seated on the first bracket 310. The second bracket 360 may be secured to the first bracket 310 so that the arm module 500 seated on the first bracket 310 may be fastened. For example, the first bracket 310 may include a rail portion 311, a base portion 510, and a sidewall portion 520. Rotators (e.g., the rotators 320 of FIG. 3) may be rotatably coupled to the rail portion 311. The arm module 500 including the arms 330, the set of gears 340, the shafts 350, the cam 380, the elastic member 370, and the second bracket 360 may be supported by the base portion 510. The sidewall portion 520 may vertically extend from the base portion 510. The sidewall portion 520 may include a groove 521 into which a portion (e.g., a second portion 720 of FIG. 8) of the second bracket 360 is inserted. A cross-section of the base portion 510 and the sidewall portion 520 may be an L-shape.

According to an embodiment, the second bracket 360 may be pressed by the elastic member 370. For example, the elastic member 370 may be pressed by the second bracket 360 and the cam 380. The elastic member 370 may be seated on the base portion 510 of the first bracket 310 in a state compressed by the second bracket 360 and the cam 380. The sidewall portion 520 may include receiving portions 522 for receiving the shafts 350 protruding from the second bracket 360.

According to an embodiment, before the arm module 500 is seated on the first bracket 310, the elastic member 370 may be in an uncompressed original state. When the elastic member 370 is in the original state, a length (e.g., a length in a y-axis direction) of the arm module 500 may be longer than a length of the base portion 510. When the arm module 500 is seated on the base portion 510 of the first bracket 310, the second bracket 360 may press the elastic member 370 to compress the elastic member 370. For example, by an assembly jig for assembling the arm module 500 and the first bracket 310, the second bracket 360 may be pressed in a direction (e.g., a +y direction) facing the cam 380.

For example, as the second bracket 360 is pressed in the direction, the elastic member 370 may be pressed by the second bracket 360. The elastic member 370 may be compressed by the pressure from the second bracket 360. The assembly jig may press the second bracket 360 so that the length of the arm module 500 is shorter than the length of the base portion 510. In a state that the elastic member 370 is compressed, the arm module 500 may be seated on the base portion 510. When the assembly jig is separated from the arm module 500, the elastic member 370 may extend by a restoring force of the elastic member 370. The elastic member 370 may push the second bracket 360 toward the sidewall portion 520 of the first bracket 310. The second bracket 360 pressed by the elastic member 370 may be secured to the first bracket 310. As the second bracket 360 is secured to the first bracket 310, the arm module 500 may be fastened to the first bracket 310.

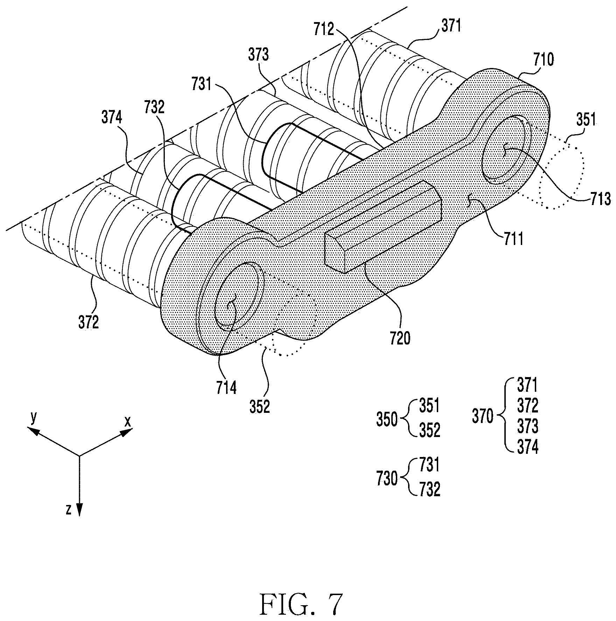

FIG. 7 is a perspective view of a second bracket.

Referring to FIG. 7, a second bracket 360 may include a first portion 710 and a second portion 720.

According to an embodiment, the first portion 710 of the second bracket 360 may fasten shafts 350. For example, the first portion 710 of the second bracket 360 may define (or form) openings 713 and 714 into which the shafts 350 are inserted, respectively. Each of the shafts 350 may be fastened to the second bracket 360 by being inserted into a corresponding opening of the openings 713 and 714. The openings 713 and 714 may include the first opening 713 and the second opening 714. A first shaft 351 coupled to a first gear (e.g., the first gear g1 of FIG. 4) may be fastened to the second bracket 360 by being inserted into the first opening 713. A second shaft 352 coupled to a second gear (e.g., the second gear g2 of FIG. 4) may be fastened to the second bracket 360 by being inserted into the second opening 714. The second portion 720 of the second bracket 360 may be disposed between the first opening 713 and the second opening 714. Since one or more idle gears (e.g., the one or more idle gears g3 and g4 of FIG. 3) are disposed between driving gears (e.g., the driving gears g1 and g2 of FIG. 3), the first shaft 351 and the second shaft 352 may be spaced apart from each other. As the second portion 720 is disposed between the first opening 713 and the second opening 714, an area of the second bracket 360 coupled to a first bracket (e.g., the first bracket 310 of FIG. 5) may be ensured.

According to an embodiment, the second portion 720 of the second bracket 360 may protrude from the first portion 710 of the second bracket 360. For example, the first portion 710 of the second bracket 360 may include a first surface 711 and a second surface 712 opposite the first surface 711. The first surface 711 may be referred to as a surface of the first portion 710 toward a sidewall portion (e.g., the sidewall portion 520 of FIG. 5) of the first bracket 310. The second surface 712 may be referred to as a surface of the first portion 710 facing a cam (e.g., the cam 380 of FIG. 4). The second portion 720 of the second bracket 360 may protrude from the first surface 711 of the first portion 710. The second portion 720, which is a portion secured to the first bracket 310, may be inserted into a groove (e.g., a groove 521 of FIG. 8) of the first bracket 310 by being pressed by an elastic member 370, as described later.

According to an embodiment, the second bracket 360 may further include a third portion 730. The third portion 730 of the second bracket 360 may protrude from the second surface 712 of the first portion 710. The third portion 730 of the second bracket 360 may support a portion of the elastic member 370.

According to an embodiment, the elastic member 370 may include a coil spring, but is not limited thereto. For example, the elastic member 370 may include a first coil spring 371, a second coil spring 372, a third coil spring 373, and a fourth coil spring 374. For example, the third portion 730 of the second bracket 360 may include a first protruding portion 731 and a second protruding portion 732. The first coil spring 371 may be supported by the first shaft 351 by being disposed to cover an outer surface of the first shaft 351. The second coil spring 372 may be supported by the second shaft 352 by being disposed to cover an outer surface of the second shaft 352. The third coil spring 373 may be supported by the first protruding portion 731 by being disposed to cover the first protruding portion 731 of the third portion 730. The fourth coil spring 374 may be supported by the second protruding portion 732 by being disposed to cover the second protruding portion 732 of the third portion 730.

FIG. 8 is a cross-sectional view in which the hinge assembly of FIG. 4 is cut along line A-A'.

Referring to FIG. 8, an elastic member 370 may be pressed by a cam 380 and a second bracket 360. For example, in a state that the second bracket 360 is secured to a first bracket 310, the elastic member 370 may press the second bracket 360 toward a sidewall portion 520 of the first bracket 310. The sidewall portion 520 of the first bracket 310 facing a second portion 720 of the second bracket 360 may include a groove 521. The second portion 720 of the second bracket 360 may be inserted into the groove 521 of the first bracket 310 by the pressure from the elastic member 370. The second portion 720 of the second bracket 360 protruding from a first portion 710 of the second bracket 360 may be inserted into the groove 521 of the first bracket 310 by the elastic member 370. The second bracket 360 may be secured to the first bracket 310 via the second portion 720 of the second bracket 360 inserted into the groove 521 of the first bracket 310. For example, the second portion 720 of the second bracket 360 may have a shape corresponding to a shape of the groove 521 of the first bracket 310 so that it may be firmly secured to the first bracket 310 via the second portion 720 of the second bracket 360 inserted into the groove 521. The elastic member 370 may support the second portion 720 of the second bracket 360 inserted into the groove 521 of the first bracket 310 by pressing the second bracket 360 toward the sidewall portion 520 of the first bracket 310. The first portion 710 of the second bracket 360 may be supported by a base portion 510 of the first bracket 310.

According to an embodiment, a hinge assembly 250 may include the second bracket 360 secured to the first bracket 310 without including a separate structure (e.g., a ring structure) for fastening shafts (e.g., the shafts 350 of FIG. 7). Since the second bracket 360 fastening shafts 350 may be directly secured to the first bracket 310, the separate structure for fastening the shafts 350 may be omitted. As the separate structure for fastening the shafts 350 is omitted, the shafts 350 may not include a groove for securing with the structure. Since the shafts 350 do not include the groove, a thickness of the shafts 350 may become thinner. For example, since the shafts 350 do not include the groove, a diameter of each of the shafts 350 may be substantially constant. According to an embodiment, an overall thickness of the hinge assembly 250 may become thinner, and thus a space for disposing other components inside a foldable electronic device (e.g., the foldable electronic device 200 of FIG. 2A) may be ensured. Alternatively, according to an embodiment, since the thickness of the shafts 350 may become thinner, a thickness of each of elastic members 371 and 372 covering each of shafts 351 and 352 may be increased as a thickness of each of the shafts 351 and 352 becomes thinner, thereby increasing a torque value and an elastic modulus of the elastic members 371 and 372.

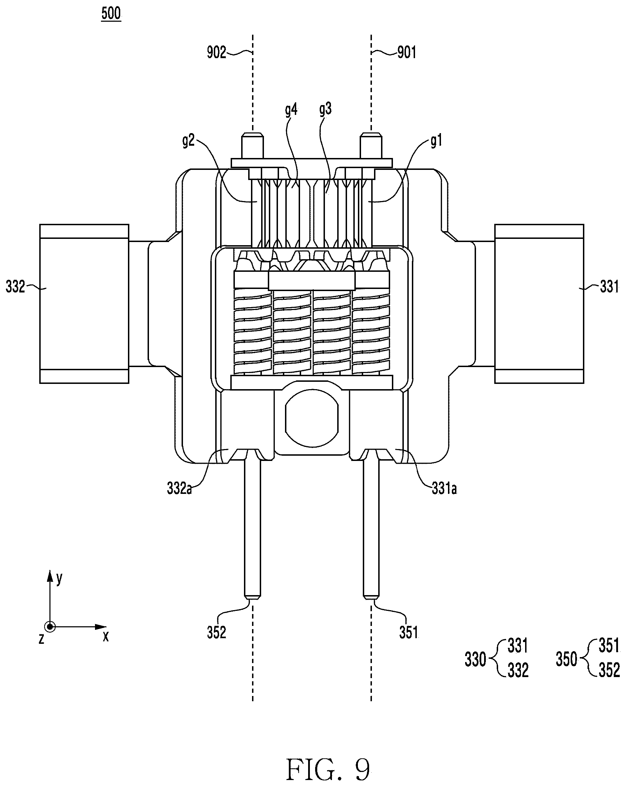

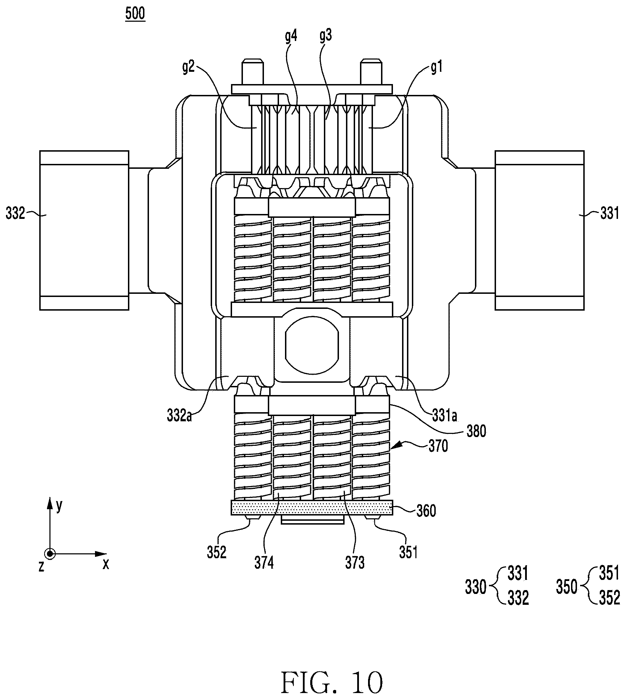

FIG. 9 illustrates an arm module in a state before assembling a cam, an elastic member, and a second bracket. FIG. 10 illustrates an arm module in a state in which a cam, an elastic member, and a second bracket are assembled to the arm module of FIG. 9.

Referring to FIG. 9, in an arm module 500 in the state before assembling the second bracket (e.g., a second bracket 360 of FIG. 10), shafts 350 may penetrate driving gears g1 and g2 and arms 330. As described above, a set of gears 340 may include the driving gears g1 and g2 configured to rotate in conjunction with the arms 330 and one or more idle gears g3 and g4 engaged with the driving gears g1 and g2. For example, a driving gear may include the first gear g1 and the second gear g2, and the one or more idle gears g3 and g4 may include the third gear g3 and the fourth gear g4. Each of the driving gears g1 and g2 may be integrally formed with each of the arm module 500. For example, the first gear g1 may be integrally formed with a first arm 331, and the second gear g2 may be integrally formed with a second arm 332. The first arm 331 may include a first support portion 331a spaced apart from the first gear g1. The second arm 332 may include a second support portion 332a spaced apart from the second gear g2.

According to an embodiment, a first shaft 351 may penetrate the first gear g1 and the first support portion 331a. The first shaft 351 may fasten a rotation shaft 901 of the first gear g1, and the first gear g1 may be configured to rotate around the rotation shaft 901. A second shaft 352 may penetrate the second gear g2 and the second support portion 332a. The second shaft 352 may fasten a rotation shaft 902 of the second gear g2, and the second gear g2 may be configured to rotate around the rotation shaft 902. A portion of the first shaft 351 may protrude from the first support portion 331a, and a portion of the second shaft 352 may protrude from the second support portion 332a.

Referring to FIG. 10, a cam 380, a portion (e.g., a third coil spring 373 and a fourth coil spring 374) of an elastic member 370, and the second bracket 360 may be coupled to the shafts 350. As the cam 380, the portion of the elastic member 370, and the second bracket 360 are coupled to the shafts 350, an assembly of the arm module 500 may be completed.

According to an embodiment, the shafts 350 may penetrate the cam 380 and be inserted into the second bracket 360. As described with reference to FIG. 7, the first shaft 351 may be fastened to the second bracket 360 by being inserted into a first opening (e.g., the first opening 713 of FIG. 7) of the second bracket 360, and the second shaft 352 may be fastened to the second bracket 360 by being inserted into a second opening (e.g., the second opening 714 of FIG. 7) of the second bracket 360. The portion of the elastic member 370 may be supported by the shafts 350 or the second bracket 360. A first coil spring 371 may be supported by the first shaft 351 by being disposed to cover an outer surface of the first shaft 351. A second coil spring 372 may be supported by the second shaft 352 by being disposed to cover an outer surface of the second shaft 352. The third coil spring 373 may be supported by a first protruding portion 731 by being disposed to cover the first protruding portion 731 of a third portion 730. The fourth coil spring 374 may be supported by a second protruding portion 732 by being disposed to cover the second protruding portion 732 of the third portion 730.

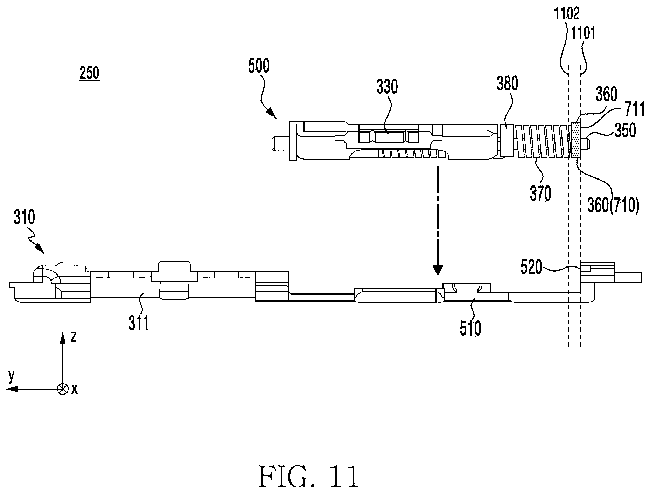

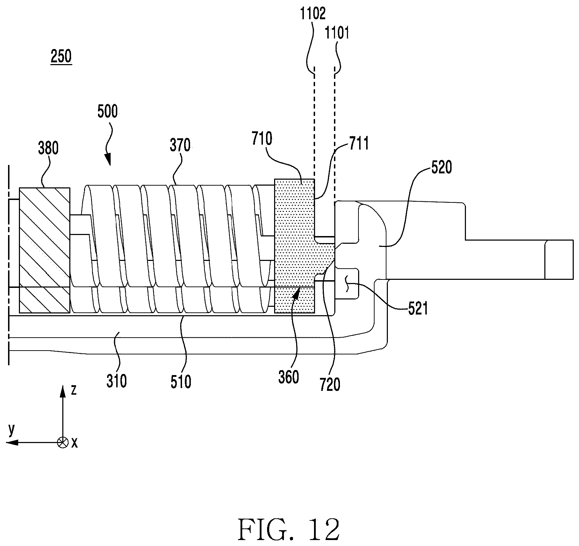

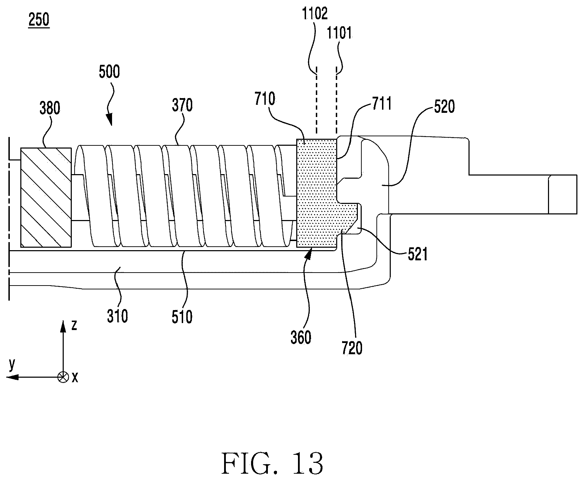

FIG. 11 illustrates a process of settling an arm module on a first bracket. FIGS. 12 and 13 illustrate processes in which a second bracket is secured to a first bracket.

Referring to FIG. 11, an assembled arm module 500 may be seated on a base portion 510 of a first bracket 310. In a case that an elastic member 370 is not compressed, a length (e.g., a length in a y-axis direction) of the arm module 500 may be longer than a length of the base portion 510. For example, when an end of the base portion 510 adjacent to a rail portion 311 and an end of the arm module 500 corresponding to the end of the base portion 510 are aligned, another end of the arm module 500 may not be aligned with another end of the base portion 510. For example, a first surface 711 of a first portion 710 of a second bracket 360 may overlap a sidewall portion 520.

In a state that the elastic member 370 is not compressed, the first surface 711 of the first portion 710 of the second bracket 360 may be positioned on a first virtual line 1101 of FIG. 11 overlapping the sidewall portion 520 of the first bracket 310. In a case that the first surface 711 of the first portion 710 of the second bracket 360 is positioned on the first virtual line 1101, since the arm module 500 may not be seated on the base portion 510, the elastic member 370 may be compressed to seat the arm module 500 on the first bracket 310.

For example, the elastic member 370 may be pressed in a direction (e.g., a +y direction) toward a cam 380 by an assembly jig. As the elastic member 370 is pressed in the direction toward the cam 380, the elastic member 370 may be compressed. As the elastic member 370 is compressed, the length of the arm module 500 may be decreased. In the present disclosure, the length of the arm module 500, which is a length in a direction parallel to a rotation shaft of a hinge assembly 250, may be referred to as the length in the y-axis direction of FIG. 11. For example, according to the compression of the elastic member 370, the first surface 711 of the first portion 710 of the second bracket 360 may move toward the cam 380. In a state that the elastic member 370 is compressed, according to the movement of the second bracket 360, the first surface 711 of the first portion 710 of the second bracket 360 may be positioned on a second virtual line 1102 of FIG. 11 overlapping the base portion 510 of the first bracket 310. As the elastic member 370 is pressed by the assembly jig, while the first surface 711 of the first portion 710 of the second bracket 360 is positioned on the second virtual line 1102, the arm module 500 may be seated on the base portion 510 of the first bracket 310.

FIG. 12 illustrates a state before the second bracket 360 is secured to the first bracket 310. For example, FIG. 12 illustrates a state before the arm module 500 is fully seated on the base portion 510 of the first bracket 310.

Referring to FIG. 12, as the arm module 500 is adjacent to the base portion 510 of the first bracket 310, the first portion 710 of the second bracket 360 may be adjacent to the base portion 510 of the first bracket 310. The elastic member 370 may maintain a compressed state by being pressed by the cam 380 and the second bracket 360. While the compressed state of the elastic member 370 is maintained, the first surface 711 of a bracket may be positioned on the second virtual line 1102.

According to an embodiment, since the compressed state of the elastic member 370 is maintained, the elastic member 370 may press the second bracket 360 by a restoring force of the elastic member 370. For example, in a state that the elastic member 370 is not pressed, since first surface 711 of the first portion 710 of the second bracket 360 is positioned on the first virtual line 1101, the elastic member 370 may push the second bracket 360 so that the first surface 711 of the first portion 710 of the second bracket 360 is positioned on the first virtual line 1101. A second portion 720 of the second bracket 360 protruding from the first portion 710 of the second bracket 360 may be pressed in a direction (e.g., a -y direction) toward the sidewall portion 520 of the first bracket 310 by the restoring force of the elastic member 370. In a state before the arm module 500 is fully seated on the base portion 510 of the first bracket 310, since the second portion 720 of the second bracket 360 is not aligned with a groove 521 of the first bracket 310, even though the second portion 720 is pressed by the elastic member 370, the second portion 720 may not be inserted into the groove 521.

FIG. 13 illustrates a state that the second bracket 360 is secured to the first bracket 310. For example, FIG. 13 illustrates a state that the arm module 500 is fully seated on the base portion 510 of the first bracket 310.

Referring to FIG. 13, as the arm module 500 is seated on the base portion 510 of the first bracket 310, the second portion 720 of the second bracket 360 may be aligned with the groove 521 of the sidewall portion 520 of the first bracket 310. The elastic member 370 may press the second bracket 360 in the direction (e.g., the -y direction) toward the sidewall portion 520 of the first bracket 310, and when the second portion 720 of the second bracket 360 is aligned with the groove 521 of the first bracket 310, the second portion 720 may be inserted into the groove 521 by the pressure from the elastic member 370. When the second portion 720 of the second bracket 360 is inserted into the groove 521 of the first bracket 310, the first surface 711 positioned on the second virtual line 1102 of the first portion 710 of the second bracket 360 may move to be positioned on the first virtual line 1101.

According to an embodiment, as the second portion 720 of the second bracket 360 is inserted into the groove 521 of the first bracket 310, the second bracket 360 may be firmly secured to the first bracket 310. Even though a force less than magnitude capable of compressing the elastic member 370 is applied to the second bracket 360, since the elastic member 370 is not compressed, the second bracket 360 may maintain a state of being secured to the first bracket 310. A securing structure of the first bracket 310 and the second bracket 360 may be referred to as a hook structure using the elastic member 370. As the second bracket 360 is directly secured to the first bracket 310, a separate structure for fastening shafts (e.g., the shafts 350 of FIG. 3) may be omitted, and thus a thickness of a hinge assembly 250 may be decreased.

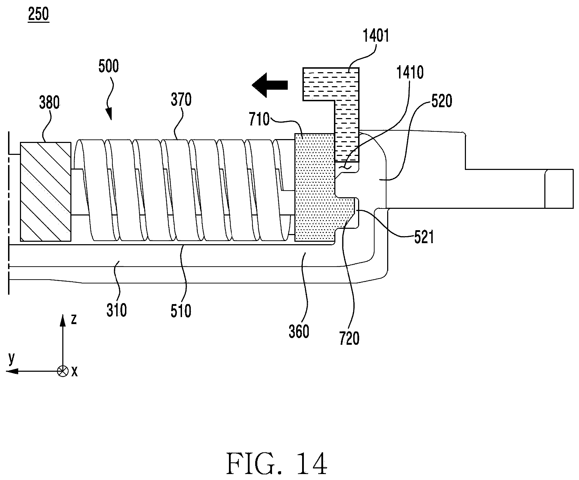

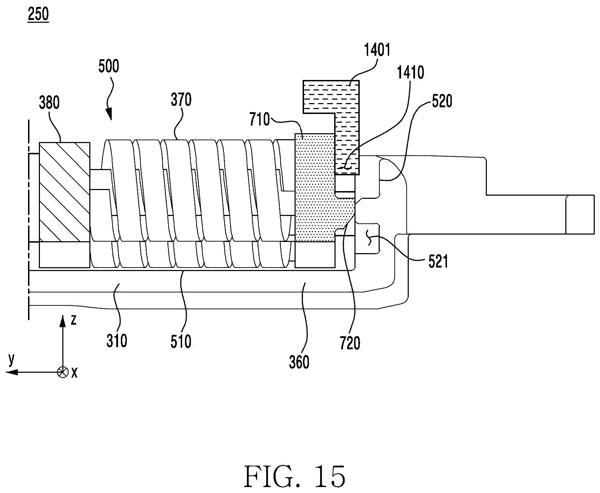

FIGS. 14 and 15 illustrate processes in which an arm module is separated from a first bracket.

For a repair of a hinge assembly 250 or a replacement of some components, a second bracket 360 may be separated from a first bracket 310. For example, in a case that the second bracket 360 is integrally formed with the first bracket 310, a separation of the first bracket 310 and the second bracket 360 may be impossible. In this case, a reassembly of the hinge assembly 250 or the replacement of some components may be impossible. According to an embodiment, since the hinge assembly 250 includes the first bracket 310 and the second bracket 360 secured to each other via a hook structure, it may be possible to separate the second bracket 360 from the first bracket 310.

Referring to FIG. 14, the first bracket 310 may include a recess 1410. For example, the recess 1410 may be formed in a sidewall portion 520 of the first bracket 310. The recess 1410 may be spaced apart from a groove 521 of the first bracket 310. The recess 1410 may define a space (or an internal volume) between the first bracket 310 and the second bracket 360 (e.g., the sidewall portion 520).

According to an embodiment, the recess 1410 may provide a space into which a disassembly jig 1401 for separating the second bracket 360 from the first bracket 310 is inserted. Since an elastic member 370 presses the second bracket 360 toward the sidewall portion 520, a second portion 720 of the second bracket 360 may maintain a state of being inserted into the groove 521 of the first bracket 310. In order to separate the second bracket 360 from the first bracket 310, compression of the elastic member 370 may be required. The space between the first bracket 310 and the second bracket 360 defined by the recess 1410 may be used as a space into which the disassembly jig 1401 is inserted, in order to press the elastic member 370 in a direction (e.g., a +y direction) toward a cam 380 by the disassembly jig 1401.

FIG. 14 illustrates a state in which the disassembly jig 1401 is inserted into the space. For example, the disassembly jig 1401 may be inserted into the space between the first bracket 310 and the second bracket 360 (e.g., the sidewall portion 520) defined by the recess 1410. The disassembly jig 1401 may press the second bracket 360 toward the cam 380 after being inserted into the space. The second bracket 360 may move toward the cam 380 according to the pressure from the disassembly jig 1401. According to the movement of the second bracket 360, the elastic member 370 may be compressed. The second portion 720 of the second bracket 360 may be extracted from the groove 521 of the first bracket 310 according to the pressure from the disassembly jig 1401. When the second portion 720 of the second bracket 360 is extracted from the groove 521 of the first bracket 310, the securing between the first bracket 310 and the second bracket 360 may be released.

FIG. 15 illustrates a state in which an arm module 500 is detached from the first bracket 310. Referring to FIG. 15, as the second portion 720 of the second bracket 360 is extracted from the groove 521 of the first bracket 310 by the disassembly jig 1401, the securing between the first bracket 360 and the second bracket 360 may be released. When the securing between the first bracket 310 and the second bracket 360 is released, the arm module 500 may be separated from the first bracket 310. For example, while the disassembly jig 1401 presses the second bracket 360 to compress the elastic member 370, the arm module 500 may be separated out of a base portion 510 of the first bracket 310.

Since the hinge assembly 250 according to an embodiment includes the first bracket 310 and the second bracket 360 secured to each other via the hook structure, the separation of the first bracket 310 and the second bracket 360 may be possible. Since the separation of the first bracket 310 and the second bracket 360 is possible by using the disassembly jig 1401, the repair of the hinge assembly 250 and the replacement of some components of the hinge assembly 250 may be possible.

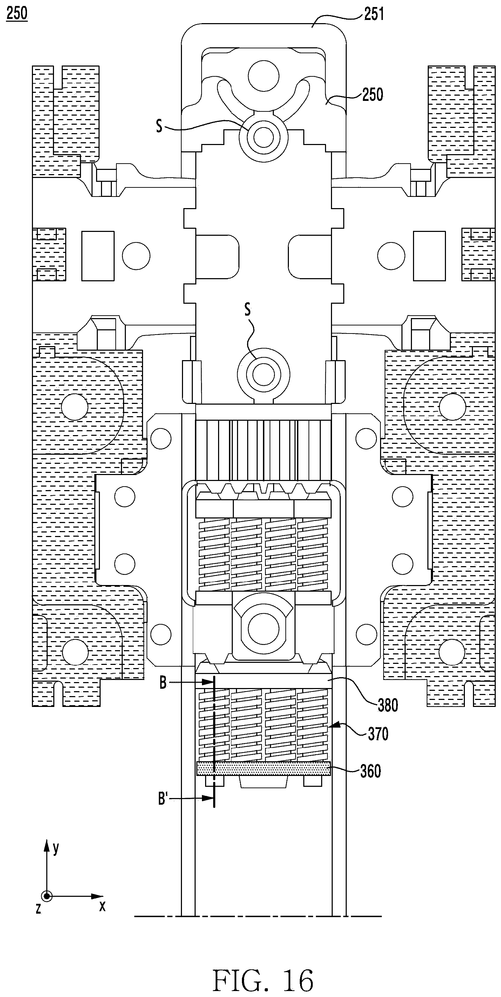

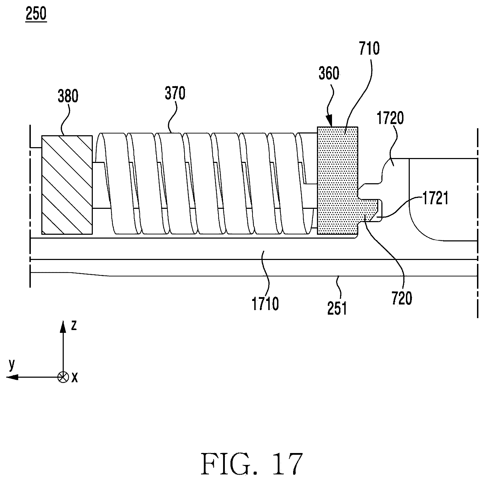

FIG. 16 illustrates a hinge assembly according to an embodiment. FIG. 17 is a cross-sectional view in which the hinge assembly of FIG. 16 is cut along line B-B'.

In FIG. 4, the hinge assembly 250 has been described as a structure in which the first bracket 310 is secured to the hinge cover 251, but the present disclosure is not limited thereto.

Referring to FIG. 16, both a first bracket 310 and a second bracket 360 may be secured to a hinge cover 251.

According to an embodiment, the first bracket 310 and the second bracket 360 may be respectively secured to the hinge cover 251. For example, the first bracket 310 may define (or form) an opening for insertion of a screw S. The screw S may be secured to the hinge cover 251 by penetrating the opening of the first bracket 310. For example, the second bracket 360 and the hinge cover 251 may be secured to each other via a structure corresponding to the hook structure described above.

Referring to FIG. 17, the hinge cover 251 may include a groove 1721 into which a second portion 720 of the second bracket 360 is inserted. The second portion 720 of the second bracket 360 may be inserted into the groove 1721 of the hinge cover 251 by being pressed by an elastic member 370. The second bracket 360 may be secured to the hinge cover 251 via the second portion 720 of the second bracket 360 inserted into the groove 1721 of the hinge cover 251. For example, the hinge cover 251 may include the second bracket 360, the elastic member 370, a base portion 1710 supporting a cam 380, and a sidewall portion 1720 including the groove 1721. According to an embodiment, since a base portion (e.g., the base portion 510 of FIG. 5) of the first bracket 310 and a sidewall portion (e.g., the sidewall portion 520 of FIG. 5) of the first bracket 310 may be omitted, a structure of the hinge assembly 250 may be simplified.

In the examples described above, the foldable electronic device 200 has been described as including two housing parts (e.g., the first housing part 210 and the second housing part 220 of FIG. 2A), but the present disclosure is not limited thereto. For example, the foldable electronic device 200 may include three housing parts and two hinge assemblies (e.g., a first hinge assembly 250 and a second hinge assembly 1860 of FIG. 18). The securing structure of the first bracket 310 and the second bracket 360 described above may be applied to at least one of the two hinge assemblies.

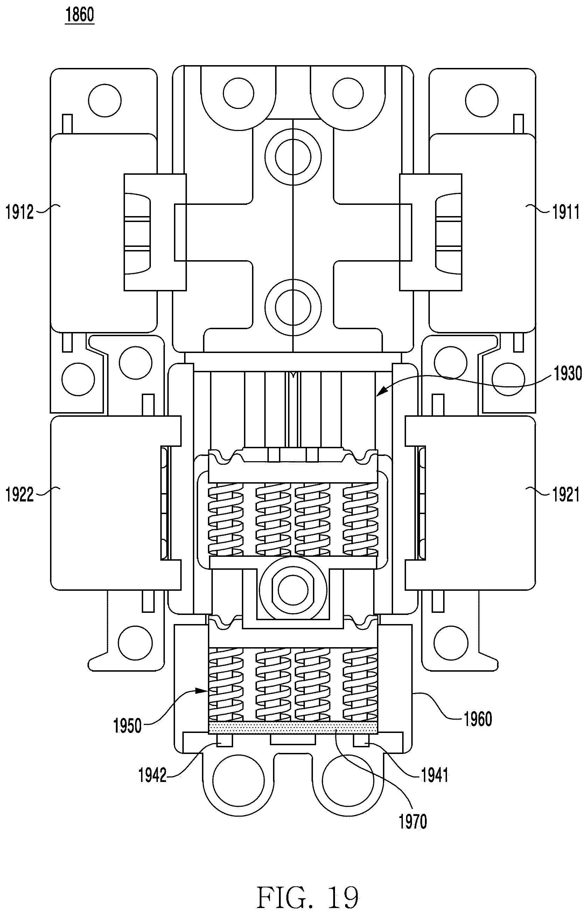

FIG. 18 illustrates a foldable electronic device according to an embodiment. FIG. 19 illustrates the second hinge assembly of FIG. 18.

A foldable electronic device 200 (e.g., the electronic device 101 of FIG. 1) according to an embodiment may include a plurality of housing parts rotatably coupled. Referring to FIG. 18, the foldable electronic device 200 may include a first housing part 210, a second housing part 220, and a third housing part 1830. The first housing part 210 and the second housing part 220 may be rotatably connected to each other, and the second housing part 220 and the third housing part 1830 may be rotatably connected to each other. The foldable electronic device 200 may include a first hinge assembly 250 rotatably connecting the first housing part 210 and the second housing part 220, and a second hinge assembly 1860 rotatably connecting the second housing part 220 and the third housing part 1830.

According to an embodiment, the first housing part 210 may be rotatably coupled to a side of the second housing part 220. The third housing part 1830 may be rotatably coupled to another side of the second housing part 220. The foldable electronic device 200 may include the first hinge assembly 250 that rotatably couples the first housing part 210 to the side of the second housing part 220 and the second hinge assembly 1860 that rotatably couples the third housing part 1830 to the side of the second housing part 220. The foldable electronic device 200 may have a structure that may be folded twice by the first hinge assembly 250 and the second hinge assembly 1860.

The foldable electronic device 200 according to an embodiment may include a flexible display 1840. In a case that a foldable housing 201 is folded or unfolded, the flexible display 1840 may also be folded or unfolded.

A first state 200a of FIG. 18 may be referred to as an unfolded state of the foldable electronic device 200. The first state 200a may indicate a state in which the first housing part 210, the second housing part 220, and the third housing part 1830 are fully unfolded. In the unfolded state of the foldable electronic device 200, the first housing part 210, the second housing part 220, and the third housing part 1830 may be disposed on substantially the same plane. The first state 200a may be referred to as an opened state, a flat state, and/or an outspread state in terms of the first housing part 210, the second housing part 220, and the third housing part 1830 being fully unfolded. In the first state 200a, the second housing part 220 may be positioned between the first housing part 210 and the third housing part 1830.

A second state 200b of FIG. 18 may indicate a state in which the first housing part 210 is folded with respect to the second housing part 220. As the first housing part 210 is rotated with respect to the second housing part 220 in the first state 200a, the foldable electronic device 200 may change from the first state 200a to the second state 200b. For example, the first housing part 210 may rotate in a first direction (e.g., counterclockwise) with respect to the second housing part 220 via the first hinge assembly 250. When the first housing part 210 is rotated by about 180 degrees, the second state 200b in which the first housing part 210 is placed above the second housing part 220 may be provided. The second state 200b may be referred to as a sub-unfolded state, a sub-folded state, an intermediate state, and/or a concave state.

A third state 200c of FIG. 18 may be referred to as a folded state of the foldable electronic device 200. The third state 200c may indicate a state in which the first housing part 210, the second housing part 220, and the third housing part 1830 are fully folded. In the folded state of the foldable electronic device 200, when the foldable electronic device 200 is viewed from above, the second housing part 220, the first housing part 210, and the third housing part 1830 may overlap each other. In the second state 200b, as the third housing part 1830 is rotated with respect to the second housing part 220, the foldable electronic device 200 may change from the second state 200b to the third state 200c. For example, the third housing part 1830 may rotate in a second direction (e.g., clockwise) opposite to the first direction with respect to the second housing part 220 via the second hinge assembly 1860. In the second state 200b, when the third housing part 1830 is rotated by about 180 degrees, the third state 200c in which the third housing part 1830 is placed above the first housing part 210 may be provided. In the third state 200c, the flexible display 1840 may not be exposed to an outside of the foldable electronic device 200 by being blocked by the second housing part 220, the first housing part 210, and/or the third housing part 1830. In a third state, the first housing part 210 may be positioned between the second housing part 220 and the third housing part 1830. In the third state, a cover display 1840 disposed in the third housing part 1830 may be exposed to the outside. The third state 200c may be referred to as a closed state in terms of the first housing part 210, the second housing part 220, and the third housing part 1830 being fully folded.

According to an embodiment, the first hinge assembly 250 and the second hinge assembly 1860 may be different. For example, the second hinge assembly 1860 may have a width wider than the first hinge assembly 250 so that the first housing part 210 may be positioned between the second housing part 220 and the third housing part 1830 in the third state 200c. In terms of having different widths, the first hinge assembly 250 may be referred to as a narrow hinge, and the second hinge assembly 1860 may be referred to as a wide hinge.

According to an embodiment, the first hinge assembly 250 and the second hinge assembly 1860 may include the hook structure of the hinge assembly 250 described above. For example, the first hinge assembly 250 may substantially correspond to the hinge assembly 250 illustrated in FIG. 4 or the hinge assembly 250 illustrated in FIG. 16.

Referring to FIG. 19, the second hinge assembly 1860 may include rotators 1911 and 1912, arms 1921 and 1922, a set of gears 1930, shafts 1941 and 1942, an elastic member 1950, a third bracket 1960, and a fourth bracket 1970. Each of the rotators 1911 and 1912, the arms 1921 and 1922, the set of gears 1930, the shafts 1941 and 1942, the elastic member 1950, the third bracket 1960, and the fourth bracket 1970 of the second hinge assembly 1860 may substantially correspond to each of the rotators (e.g., the rotators 320 of FIG. 3), the arms (e.g., the arms 330 of FIG. 3), the set of gears (e.g., the set of gears 340 of FIG. 3), the shafts (e.g., the shafts 350 of FIG. 3), the elastic member (e.g., the elastic member 370 of FIG. 3), the first bracket (e.g., the first bracket 310 of FIG. 3), and the second bracket (e.g., the second bracket 360 of FIG. 3) described above.

For example, the rotators 1911 and 1912 of the second hinge assembly 1860 may be configured to guide a rotation of the second housing part (e.g., the second housing part 220 of FIG. 18) and the rotation of the third housing part (e.g., the third housing part 1830 of FIG. 18). The rotators 1911 and 1912 of the second hinge assembly 1860 may be rotatably coupled to the third bracket 1960. The arms 1921 and 1922 of the second hinge assembly 1860 may be configured to synchronize the rotation of the second housing part 220 with the rotation of the third housing part 1830. The set of gears 1930 of the second hinge assembly 1860 may include driving gears configured to rotate in conjunction with the arms 1921 and 1922 of the second hinge assembly 1860 and one or more idle gears engaged with the driving gears. Each of the shafts 1941 and 1942 of the second hinge assembly 1860 may be respectively coupled to the driving gears of the second hinge assembly 1860.

According to an embodiment, the fourth bracket 1970 may be secured to the third bracket 1960. For example, the fourth bracket 1970 may include a portion fastening the shafts 1941 and 1942 of the second hinge assembly 1860 and another portion protruding from the portion of the fourth bracket 1970. The elastic member 1950 of the second hinge assembly 1860 may press the fourth bracket 1970. The fourth bracket 1970 may be secured to the third bracket 1960 via the portion pressed by the elastic member 1950 and inserted into a groove of the third bracket 1960. According to an embodiment, since the fourth bracket 1970 may be directly secured to the third bracket 1960, the second hinge assembly 1860 may not include a structure for fastening the shafts 1941 and 1942. Since the shafts 1941 and 1942 of the second hinge assembly 1860 do not include a groove to be coupled with a separate structure, a thickness of the shafts 1941 and 1942 may be decreased.

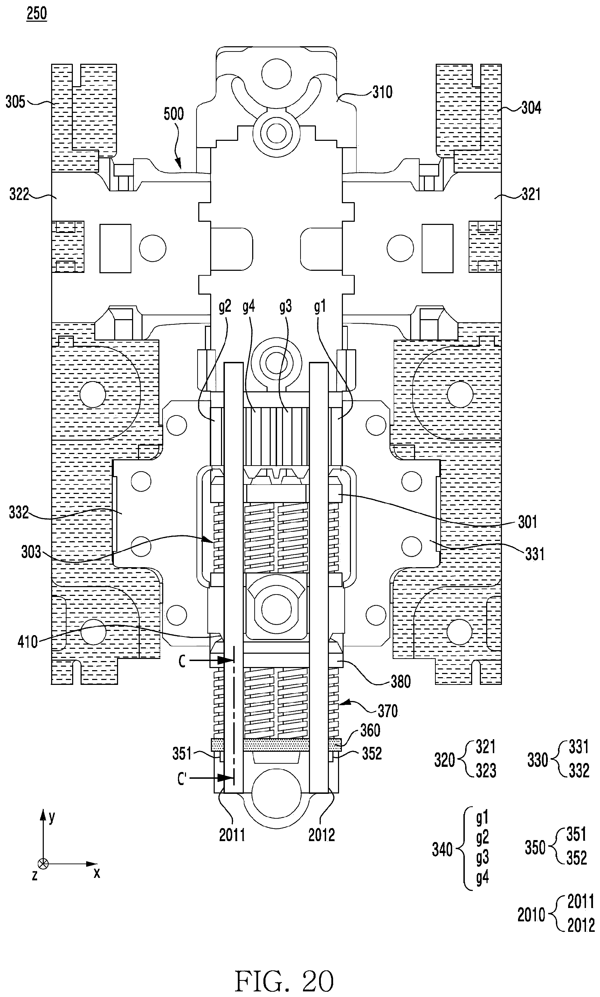

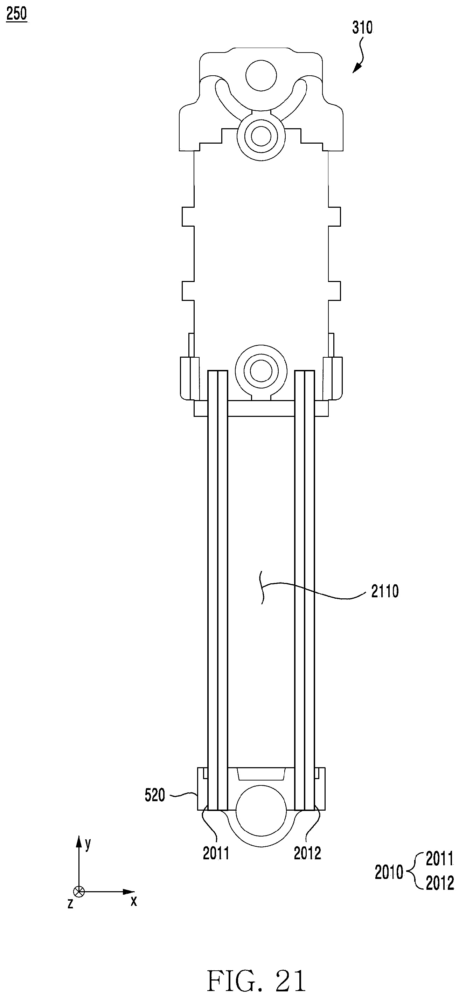

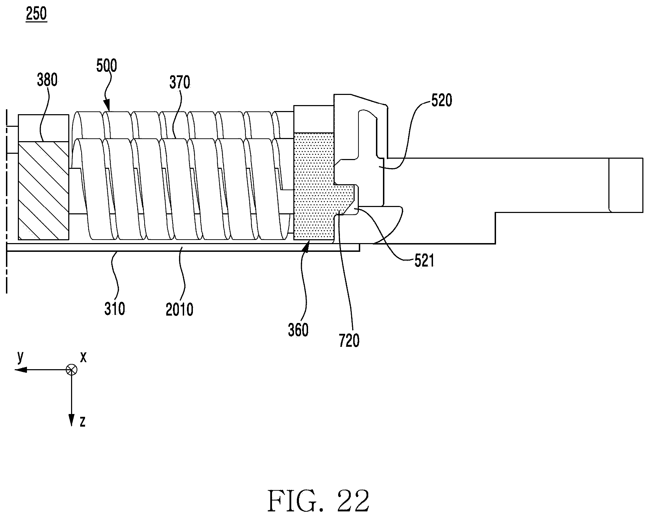

FIG. 20 illustrates a hinge assembly including a first bracket including a lower bridge. FIG. 21 illustrates a first bracket including a lower bridge. FIG. 22 is a cross-sectional view in which the hinge assembly of FIG. 21 is cut along line C-C'.

Referring to FIG. 20, a hinge assembly 250 may include a first bracket 310 including a lower bridge 2010. For example, the lower bridge 2010 may support an arm module 500 including arms 330 (e.g., a first arm 331 and a second arm 332), a set of gears 340 (e.g., a first gear g1, a second gear g2, a third gear g3, and a fourth gear g4), shafts 350 (e.g., a first shaft 351 and a second shaft 352), a cam 380, an elastic member 370, and a second bracket 360 from below.

For example, the lower bridge 2010 may include a first bridge 2011 and a second bridge 2012. The first bridge 2011 and the second bridge 2012 may extend in a folding axis direction (e.g., a y-axis direction) of the hinge assembly 250. The first bridge 2011 and the second bridge 2012 may be disposed parallel to each other. A portion of the arm module 500 may be supported by the lower bridge 2010 by being disposed on (e.g., a +z direction) the first bridge 2011 and the second bridge 2012. The lower bridge 2010 may be connected to a sidewall portion 520 coupled with the second bracket 360. Referring to FIG. 21, a base portion (e.g., the base portion 510 of FIG. 5) of the first bracket 310 may include the lower bridge 2010. As illustrated in FIG. 21, the base portion 510 on which the arm module (e.g., the arm module 500 of FIG. 20) is seated may be implemented as the lower bridge 2010. Since the lower bridge 2010 includes the first bridge 2011 and the second bridge 2012 spaced apart from each other, an opening 2110 may be formed between the first bridge 2011 and the second bridge 2012. The portion of the arm module 500 supported by the first bridge 2011 and the second bridge 2012 may be exposed via the opening 2110.

Referring to FIG. 22, the hinge assembly 250 illustrated in FIG. 20 may be substantially the same as the hinge assembly described above, except that the base portion (e.g., the base portion 510 of FIG. 5) of the first bracket 310 has been replaced with the lower bridge 2010. For example, the second bracket 360 may include a second portion 720 inserted into the groove 521 disposed in the sidewall portion 520 of the first bracket 310. A securing structure of the first bracket 310 and the second bracket 360 may be substantially the same as the structure described above.

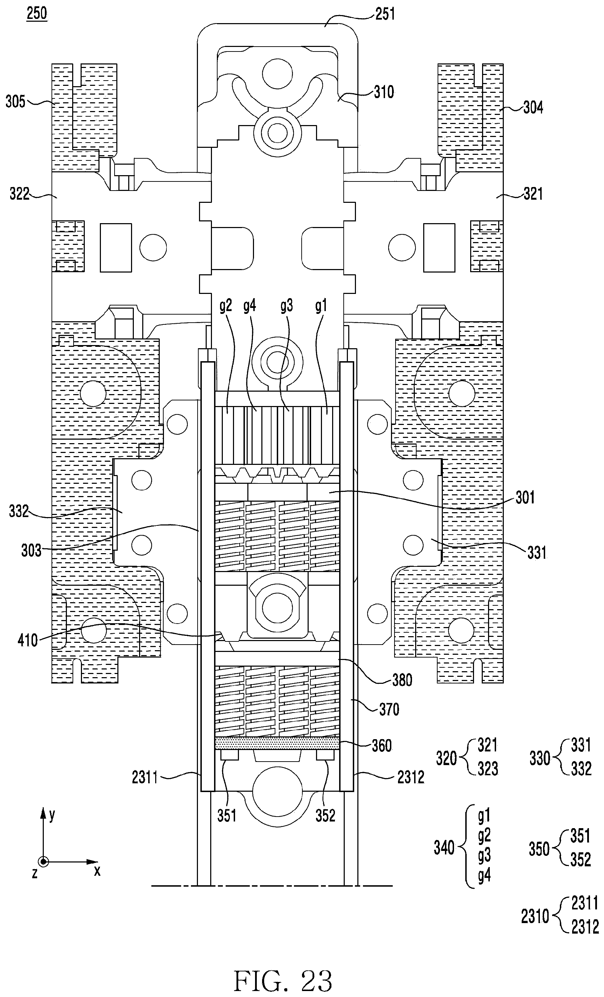

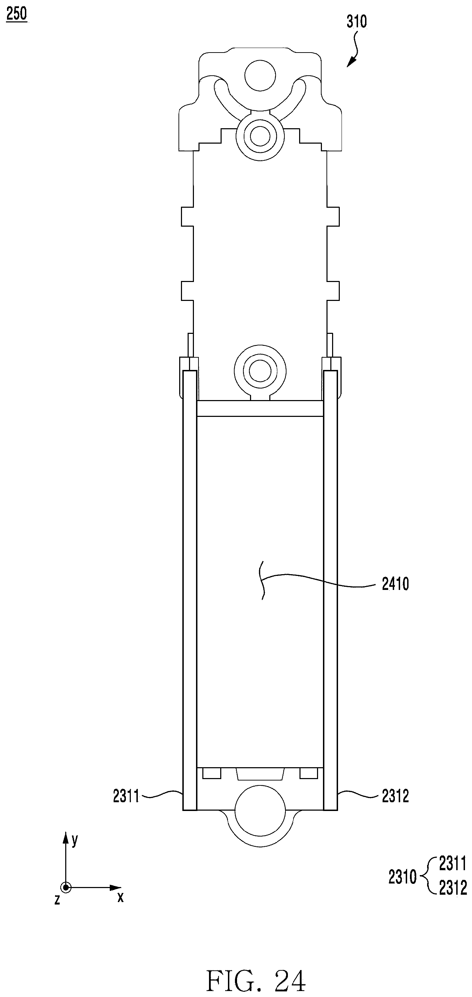

FIG. 23 illustrates a hinge assembly including a first bracket including base portions. FIG. 24 illustrates a first bracket including base portions.

Referring to FIG. 23, a hinge assembly 250 may include a first bracket 310 including a base portion 2310. For example, the base portion 2310 may support an arm module 500 including arms 330 (e.g., a first arm 331 and a second arm 332), a set of gears 340 (e.g., a first gear g1, a second gear g2, a third gear g3, and a fourth gear g4), shafts 350 (e.g., a first shaft 351 and a second shaft 352), a cam 380, an elastic member 370, and a second bracket 360 from the side.

For example, the base portion 2310 may include a first base portion 2311 and a second base portion 2312. The first base portion 2311 and the second base portion 2312 may extend in a folding axis direction (e.g., a y-axis direction) of the hinge assembly 250. The first base portion 2311 and the second base portion 2312 may be disposed parallel to each other. For example, the first base portion 2311 may face the elastic member 370 in a direction (e.g., a +x direction), and the second base portion 2312 may face the elastic member 370 in another direction (e.g., a -x direction) different from the direction. The elastic member 370 may be disposed to face a hinge cover 251, the first base portion 2311, and the second base portion 2312 in three directions. A portion of the arm module 500 may be disposed between the first base portion 2311 and the second base portion 2312 and may be laterally supported by the base portion 2310. The base portion 2310 may be connected to a sidewall portion 520 coupled with the second bracket 360. The hinge assembly 250 illustrated in FIG. 20 may be substantially the same as the hinge assembly described above, except that a base portion (e.g., the base portion 510 of FIG. 5) of the first bracket 310 is replaced with the base portion 2310.

Referring to FIG. 24, the base portion 2310 may replace the base portion (e.g., the base portion 510 of FIG. 5) of the first bracket 310. As illustrated in FIG. 24, the base portion on which an arm module (e.g., the arm module 500 of FIG. 20) is seated may be replaced with the base portion 2310. Since the base portion 2310 includes the first base portion 2311 and the second base portion 2312 spaced apart from each other, an opening 2410 may be formed between the first base portion 2311 and the second base portion 2312. The portion of the arm module 500 laterally supported by the first base portion 2311 and the second base portion 2312 may be disposed in the opening 2410.

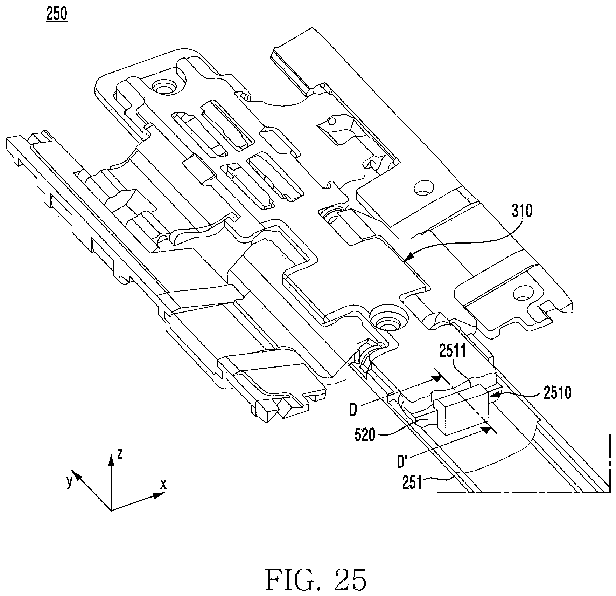

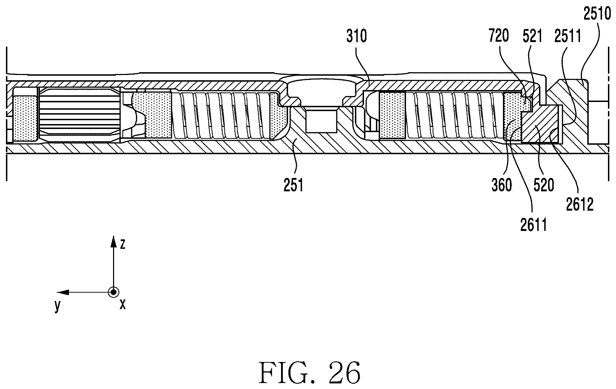

FIG. 25 is a perspective view of a hinge assembly and a hinge cover. FIG. 26 is a cross-sectional view in which the hinge assembly and the hinge cover of FIG. 25 are cut along line D-D'.

Referring to FIG. 25, a hinge cover 251 may include a protruding portion 2510 protruding upward (e.g., a +z direction) from a bottom surface of the hinge cover 251. At least a portion of a side surface 2511 (or lateral surface) of the protruding portion 2510 may face at least a portion of a sidewall portion 520 of a first bracket 310. The protruding portion 2510 may be configured to reduce a damage to a hinge assembly 250 due to an external impact or a detachment from the hinge cover 251 of the hinge assembly 250.

Referring to FIG. 26, the sidewall portion 520 of the first bracket 310 may include a surface 2611 and another surface 2612 opposite to the surface 2611. For example, a groove 521 into which a second portion 720 of a second bracket 360 is inserted may be disposed on the surface 2611 of the sidewall portion 520. For example, the other surface 2612 of the sidewall portion 520 may be opposite to the surface 2611 of the sidewall portion 520. According to an embodiment, at least a portion of the side surface 2511 (e.g., a side surface of the protruding portion 2510 facing a +y direction) of the protruding portion 2510 may face the other surface 2612 of the sidewall portion 520 on which the groove 521 is disposed. For example, the side surface 2511 of the protruding portion 2510 and the other surface 2612 of the sidewall portion 520 may face each other. The protruding portion 2510 of the hinge cover 251 may be disposed to cover the at least a portion of the sidewall portion 520 of the first bracket 310. The at least a portion of the sidewall portion 520 of the first bracket 310 may be protected from the damage caused by the external impact by being covered by the protruding portion 2510 of the hinge cover 251. In a case that the external impact is applied, the protruding portion 2510 may reduce the detachment due to the damage to the sidewall portion 520 by reducing the damage to the sidewall portion 520.

The technical problems to be addressed in the present disclosure are not limited to those described above, and other technical problems not mentioned herein will be clearly understood by those having ordinary knowledge in the art to which the present disclosure belongs.

A foldable electronic device may comprise: a foldable housing including a first housing part and a second housing part; and a hinge assembly rotatably connecting the first housing part and the second housing part. The hinge assembly may include: a first bracket; rotators, rotatably coupled to the first bracket, configured to guide a rotation of the first housing part and a rotation of the second housing part; a set of gears including driving gears configured to rotate in conjunction with a rotation of the rotators, and one or more idle gears engaged with the driving gears; shafts respectively coupled to the driving gears included in the set of gears; a second bracket including a first portion fastening the shafts and a second portion protruding from the first portion of the second bracket; and an elastic member pressing the second bracket. The second bracket, pressed by the elastic member, may be secured to the first bracket via the second portion of the second bracket inserted into a groove of the first bracket.

The hinge assembly may further include arms configured to synchronize the rotation of the first housing part with the rotation of the second housing part. The arms may comprise a first arm which is arranged to move with the first housing part, and a second arm which is arranged to move with the second housing part. The first arm may be affixed to the first housing part. The second arm may be affixed to the second housing part.

The hinge assembly may further include one or more idle gears engaged with the driving gears. The one or more idle gears may be arranged to engage with the driving gears such that a rotation of a first driving gear causes a rotation of a second driving gear. A first driving gear may arranged to rotate with the first housing part, and a second driving gear may be arranged to rotate with a second housing part. Where the first driving gear is arranged to rotate with the first housing part, and the second driving gear is arranged to rotate with the second housing part, the one or more idle gears may be arranged to engage with the driving gears such that a rotation of the first housing part causes a rotation of the second housing part by a rotation of the one or more idle gears, the first driving gear and the second driving gear.

Foldable electronic devices 101 and 200 are disclosed. The foldable electronic devices 101 and 200 may comprise a foldable housing 201 including a first housing part 210 and a second housing part 220. The foldable electronic devices 101 and 200 may comprise a hinge assembly 250 rotatably connecting the first housing part 210 and the second housing part 220. The hinge assembly 250 may include a first bracket 310. The hinge assembly 250 may include rotators 320, rotatably coupled to the first bracket 310, configured to guide a rotation of the first housing part 210 and a rotation of the second housing part 220. The hinge assembly 250 may include arms 330 configured to synchronize the rotation of the first housing part 210 with the rotation of the second housing part 220. The hinge assembly 250 may include a set of gears 340 including driving gears g1 and g2 configured to rotate in conjunction with a rotation of the arms 330, and one or more idle gears g3 and g4 engaged with the driving gears g1 and g2. The hinge assembly 250 may include shafts 350 respectively coupled to the driving gears g1 and g2 included in the set of gears 340. The hinge assembly 250 may include a second bracket 360 including a first portion 710 fastening the shafts 350 and a second portion 720 protruding from the first portion 710 of the second bracket. The hinge assembly 250 may include an elastic member 370 pressing the second bracket 360. The second bracket 360, pressed by the elastic member 370, may be secured to the first bracket 310 via the second portion 720 of the second bracket 360 inserted into a groove 521 of the first bracket 310.

The groove of the first bracket may comprise a void located between a first surface of the first bracket and a second surface of the first bracket, the first surface facing the second surface. The second portion of the second bracket may be secured by being inserted between the first surface of the first bracket and the second surface of the first bracket.

The arms may comprise a first arm which is arranged to move with the first housing part, and a second arm which is arranged to move with the second housing part. The first arm may be affixed to the first housing part. The second arm may be affixed to the second housing part.

The one or more idle gears may be arranged to engage with the driving gears such that a rotation of a first driving gear causes a rotation of a second driving gear. A first driving gear may arranged to rotate with a first arm, and a second driving gear may be arranged to rotate with a second arm. Where the first driving gear is arranged to rotate with the first arm, and the second driving gear is arranged to rotate with the second arm, the one or more idle gears may be arranged to engage with the driving gears such that a rotation of the first arm causes a rotation of the second arm by a rotation of the one or more idle gears, the first driving gear and the second driving gear.

According to an embodiment, the hinge assembly 250 may further include a cam 380 comprising a surface contacted with the arms 330 and another surface, opposite to the surface of the cam, contacted with the elastic member 370. The elastic member 370 may be configured to be compressed by the second bracket 360 and the cam 380.

According to an embodiment, each of the arms 330 may include a cam portion 410 contacted with the cam 380. The cam 380 may be configured to compress the elastic member 370 based on pressure from the cam portion 410 in accordance with the rotation of each of the arms 330. The cam 380, the cam portion 410 of each of the arms 330, and the elastic member 370 may be configured to maintain an intermediate state of the foldable electronic devices between an unfolded state of the foldable electronic devices 101 and 200 and a folded state of the foldable electronic devices 101 and 200.

According to an embodiment, the first bracket 310 may include a rail portion 311 to which the rotators 320 are rotatably coupled. The first bracket 310 may include a base portion 510 supporting the second bracket 360. The first bracket 310 may include a sidewall portion 520 perpendicular to the base portion 510 of the first bracket 310. The groove 521 of the first bracket 310 may be disposed in the sidewall portion 520 of the first bracket 310.

According to an embodiment, the base portion 510 of the first bracket 310 may support the arms 330, the set of gears 340, the shafts 350, the cam 380, the elastic member 370, and the second bracket 360.

According to an embodiment, the first bracket 310 may include a recess 1410, spaced apart from the groove 521, defining a space between the first bracket 310 and the second bracket 360.

According to an embodiment, the space between the first bracket 310 and the second bracket 360 which is defined by the recess 1410 may be used as a space into which a jig for separating the second bracket 360 from the first bracket 310 is inserted.

According to an embodiment, the first portion 710 of the second bracket 360 may define (or form) openings 713 and 714 into which each of the shafts 350 is inserted. The shafts 350 may be fastened to the second bracket 360 by being inserted into the openings 713 and 714 of the first portion 710 of the second bracket.

According to an embodiment, the second portion 720 of the second bracket 360 may protrude from a first surface 711 of the first portion 710 of the second bracket 360 facing the first bracket 310. The second bracket 360 may further include a third portion 730, protruding from a second surface 712 of the first portion 710 of the second bracket 360 opposite to the first surface 711 of the first portion 710 of the second bracket 360, supporting the elastic member 370.

According to an embodiment, the foldable electronic devices 101 and 200 may further include a hinge cover 251, partially covering the hinge assembly 250, disposed between the first housing part 210 and the second housing part 220. The first bracket 310 may be secured to the hinge cover 251.

According to an embodiment, the second bracket 360 may be separated from the hinge cover 251.

According to an embodiment, the hinge cover 251 may include a protruding portion 2510 protruding from a bottom side of the hinge cover 251. At least a portion of a surface of the protruding portion 2510 may face at least a portion of another surface 2612 opposite to a surface 2611 of the first bracket 310 in which the groove 521 is disposed.

According to an embodiment, a diameter of each of the shafts 350 may be substantially constant.

According to an embodiment, the rotators 320 may include a first rotator 321 configured to guide the rotation of the first housing part 210, and a second rotator 322 configured to guide the rotation of the second housing part 220. The arms 330 may include a first arm 331 configured to rotate in conjunction with the rotation of the first housing part 210, and a second arm 332 configured to rotate in conjunction with the rotation of the second housing part 220. The set of gears 340 may include a first gear g1 integrally formed with the first arm 331 and a second gear g2 integrally formed with the second arm 332. The first gear g1 and the second gear g2 may correspond to the driving gears g1 and g2. The set of gears 340 may include a third gear g3 engaged with the first gear g1, and a fourth gear g4, engaged with the second gear g2 and engaged with the third gear g3. The third gear g3 and the fourth gear g4 may correspond to the one or more idle gears g3 and g4. The shafts 350 may include a first shaft 351 coupled to the first gear g1, and a second shaft 352 coupled to the second gear g2.

According to an embodiment, the first portion 710 of the second bracket 360 may define (or form) a first opening 713 into which the first shaft 351 is inserted, and a second opening 714 into which the second shaft 352 is inserted. The second portion 720 of the second bracket 360 may be disposed between the first opening 713 and the second opening 714.

According to an embodiment, the foldable electronic devices 101 and 200 may further include a flexible display 230. The flexible display 230 may include a first portion 231 disposed on the first housing part 210, a second portion 232 disposed on the second housing part 220, and a third portion 233 extending from the first portion 231 of the flexible display 230 to the second portion 232 of the flexible display 230 and configured to be bent according to the rotation of the first housing part 210 and the rotation of the second housing part 220.

According to an embodiment, the foldable housing 201 may further include a third housing part 1830. The foldable electronic devices 101 and 200 may further include another hinge assembly 1860 rotatably connecting the second housing part 220 and the third housing part 1830.

According to an embodiment, the elastic member 370 may be disposed between the base portion 510 and the hinge cover 251.

According to an embodiment, the first bracket 310 may include a first base portion 2311 facing the elastic member 370 in a direction, a second base portion 2312 facing the elastic member 370 in another direction different from the direction, and a sidewall portion 520 perpendicular to the first base portion 2311 and the second base portion 2312. The groove 521 of the first bracket 310 may be disposed in the sidewall portion 520 of the first bracket 310. The elastic member 370 may be disposed to face the hinge cover 251, the first base portion 2311, and the second base portion 2312 in three different directions.

Foldable electronic devices 101 and 200 are disclosed. The foldable electronic devices 101 and 200 may comprise a foldable housing 201 including a first housing part 210 and a second housing part 220. The foldable electronic devices 101 and 200 may comprise a hinge assembly 250 rotatably connecting the first housing part 210 and the second housing part 220. The foldable electronic devices 101 and 200 may comprise a hinge cover 251, at least partially covering the hinge assembly 250. The hinge assembly 250 may include a first bracket 310. The hinge assembly 250 may include rotators 320, rotatably coupled to the first bracket 310, configured to guide a rotation of the first housing part 210 and a rotation of the second housing part 220. The hinge assembly 250 may include arms 330 configured to synchronize the rotation of the first housing part 210 with the rotation of the second housing part 220. The hinge assembly 250 may include a set of gears 340 including driving gears g1 and g2 configured to rotate in conjunction with a rotation of the arms 330, and one or more idle gears g3 and g4 engaged with the driving gears g1 and g2. The hinge assembly 250 may include shafts 350 respectively coupled to the driving gears g1 and g2 included in the set of gears 340. The hinge assembly 250 may include a second bracket 360 including a first portion 710 fastening the shafts 350 and a second portion 720 protruding from the first portion 710 of the second bracket. The hinge assembly 250 may include an elastic member 370 pressing the second bracket 360. The second bracket 360, pressed by the elastic member 370, may be secured to the hinge cover 251 via the second portion 720 of the second bracket 360 inserted into a groove 521 of the hinge cover 251.

According to an embodiment, the first bracket 310 may be secured to the hinge cover 251.

According to an embodiment, the hinge cover 251 may include a base portion 510 supporting the second bracket 360 and a sidewall portion 520 perpendicular to the base portion 510 of the first bracket 310. The groove 521 of the hinge cover 251 may be disposed in the sidewall portion 520 of the hinge cover 251.

According to an embodiment, the first portion 710 of the second bracket 360 may include openings 713 and 714 into which each of the shafts 350 is inserted. The shafts 350 may be fastened to the second bracket 360 by being inserted into the openings 713 and 714 of the first portion 710 of the second bracket.

Foldable electronic devices 101 and 200 are disclosed. The foldable electronic devices 101 and 200 may comprise a foldable housing 201 including a first housing part 210, a second housing part 220, and a hinge cover 251 disposed between the first housing part 210 and the second housing part 220. The foldable electronic devices 101 and 200 may comprise a hinge assembly 250 rotatably connecting the first housing part 210 and the second housing part 220. The hinge assembly 250 may include a first bracket 310, driving gears g1 and g2 configured to rotate in conjunction with the rotation of the first housing part 210 and the second housing part 220, shafts 350 respectively coupled to the driving gears g1 and g2, a second bracket 360 including a first portion 710 contacted with the shafts 350 and a second portion 720 protruding from the first portion 710 of the second bracket, and an elastic member 370 pressing the second bracket 360. The second bracket 360, pressed by the elastic member 370, may be secured to the first bracket 310 via the second portion 720 of the second bracket 360 inserted into a groove 521 of the first bracket 310.

According to an embodiment, the first bracket 310 may include a base portion 510 supporting the second bracket 360 in a direction and a sidewall portion 520 perpendicular to the base portion 510 of the first bracket 310. The groove 521 of the first bracket 310 may be disposed in the sidewall portion 520 of the first bracket 310.

According to an embodiment, the elastic member 370 may be disposed between the base portion 510 and the hinge cover 251.

According to an embodiment, the first bracket 310 may include a first base portion 2311 facing the elastic member 370 in a direction, a second base portion 2312 facing the elastic member 370 in another direction different from the direction, and a sidewall portion 520 perpendicular to the first base portion 2311 and the second base portion 2312. The groove 521 of the first bracket 310 may be disposed in the sidewall portion 520 of the first bracket 310. The elastic member 370 may be disposed to face the hinge cover 251, the first base portion 2311, and the second base portion 2312 in three different directions.

According to an embodiment, the hinge cover 251 may include a protruding portion 2510 protruding from a bottom side of the hinge cover 251. At least a portion of a surface of the protruding portion 2510 may face with each other at least a portion of another surface 2612 opposite to a surface 2611 in which the groove 521 of the sidewall portion 520 is disposed.

According to an embodiment, the foldable housing 201 may further include a third housing part 1830. The foldable electronic devices 101 and 200 may further include another hinge assembly 1860 rotatably connecting the second housing part 220 and the third housing part 1830. The other hinge assembly 1860 may include a third bracket 1960, driving gears 1930 configured to rotate in conjunction with the rotation of the second housing part 220 and the third housing part 1830, shafts 1941 and 1942 respectively coupled to the driving gears 1930, a fourth bracket 1970 including a third portion contacted with the shafts 1941 and 1942 and a fourth portion protruding from the third portion, and an elastic member 1950 pressing the fourth bracket. The fourth bracket 1970, pressed by the elastic member, may be secured to the third bracket 1960 via the fourth portion of the fourth bracket 1970 inserted into a groove of the third bracket 1960.

The effects that may be obtained from the present disclosure are not limited to those described above, and any other effects not mentioned herein will be clearly understood by those having ordinary knowledge in the art to which the present disclosure belongs, from the following description.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

It will be appreciated that all of the above-described embodiments, and their technical features, may be combined with one another in each and every combination, potentially unless there is a conflict between two embodiments or features. That is, each and every combination of two or more of the above-described embodiments is envisaged and included within the present disclosure. One or more features from any embodiment may be incorporated in any other embodiment, and provide a corresponding advantage or advantages.

## Claims

1. A foldable electronic device comprising:
a foldable housing including a first housing part and a second housing part; and
a hinge assembly rotatably connecting the first housing part and the second housing part, the hinge assembly including:
a first bracket,
rotators, rotatably coupled to the first bracket, configured to guide a rotation of the first housing part and a rotation of the second housing part,
arms configured to synchronize the rotation of the first housing part with the rotation of the second housing part,
a set of gears including driving gears configured to rotate in conjunction with a rotation of the arms, and one or more idle gears engaged with the driving gears,
shafts respectively coupled to the driving gears included in the set of gears,
a second bracket including a first portion fastening the shafts and a second portion protruding from the first portion of the second bracket, and
an elastic member pressing the second bracket, and
wherein the second bracket, pressed by the elastic member, is secured to the first bracket via the second portion of the second bracket inserted into a groove of the first bracket.

2. The foldable electronic device of claim 1,
wherein the hinge assembly further includes a cam comprising a surface contacted with the arms and another surface, opposite to the surface of the cam, contacted with the elastic member, and
wherein the elastic member is configured to be compressed by the second bracket and the cam.

3. The foldable electronic device of claim 2,
wherein each of the arms includes a cam portion contacted with the cam,
wherein the cam is configured to compress the elastic member based on pressure from the cam portion in accordance with the rotation of each of the arms, and
wherein the cam, the cam portion of each of the arms, and the elastic member are configured to maintain an intermediate state of the foldable electronic device between an unfolded state of the foldable electronic device and a folded state of the foldable electronic device.

4. The foldable electronic device any one of claims 1 to 3,
wherein the first bracket includes:
a rail portion to which the rotators are rotatably coupled,
a base portion supporting the second bracket, and
a sidewall portion perpendicular to the base portion of the first bracket, and
wherein the groove of the first bracket is disposed in the sidewall portion of the first bracket.

5. The foldable electronic device of claim 4,
wherein the base portion of the first bracket supports the arms, the set of gears, the shafts, the cam, the elastic member, and the second bracket.

6. The foldable electronic device any one of claims 1 to 5,
wherein the first bracket includes a recess, spaced apart from the groove, defining a space between the first bracket and the second bracket.

7. The foldable electronic device of claim 6,
wherein the space between the first bracket and the second bracket which is defined by the recess is used as a space into which a jig for separating the second bracket from the first bracket is inserted.

8. The foldable electronic device any one of claims 1 to 7,
wherein the first portion of the second bracket defines openings into which each of the shafts is inserted, and
wherein the shafts are fastened to the second bracket by being inserted into the openings of the first portion of the second bracket.

9. The foldable electronic device any one of claims 1 to 8,
wherein the second portion of the second bracket protrudes from a first surface of the first portion of the second bracket facing the first bracket, and
wherein the second bracket further includes a third portion, protruding from a second surface of the first portion of the second bracket opposite to the first surface of the first portion of the second bracket, supporting the elastic member.

10. The foldable electronic device of any one of claims 1 to 9, further comprising a hinge cover, partially covering the hinge assembly, disposed between the first housing part and the second housing part, and,
wherein the first bracket is secured to the hinge cover.

11. The foldable electronic device of claim 10,
wherein the hinge cover includes a protruding portion protruding from a bottom side of the hinge cover, and
wherein at least a portion of a lateral surface of the protruding portion faces at least a portion of a surface of the first bracket opposite to another surface of the first bracket in which the groove is disposed.

12. The foldable electronic device of claim 10,
wherein the second bracket is separated from the hinge cover.

13. The foldable electronic device any one of claims 1 to 12,
wherein a diameter of each of the shafts is substantially constant.

14. The foldable electronic device any one of claims 1 to 13,
wherein the rotators include:
a first rotator configured to guide the rotation of the first housing part, and
a second rotator configured to guide the rotation of the second housing part,
wherein the arms include:
a first arm configured to rotate in conjunction with the rotation of the first housing part, and
a second arm configured to rotate in conjunction with the rotation of the second housing part,
wherein the set of gears includes:
a first gear integrally formed with the first arm,
a second gear integrally formed with the second arm, the first gear and the second gear corresponding to the driving gears,
a third gear engaged with the first gear, and
a fourth gear, engaged with the second gear and engaged with the third gear, the third gear and the fourth gear corresponding to the idle gears, and
wherein the shafts include:
a first shaft coupled to the first gear, and
a second shaft coupled to the second gear.

15. The foldable electronic device of claim 14,
wherein the first portion of the second bracket defines:
a first opening into which the first shaft is inserted, and
a second opening into which the second shaft is inserted, and
wherein the second portion of the second bracket is disposed between the first opening and the second opening.
